(19) Europäisches Patentamt / European Patent Office / Office européen des brevets

(11) EP 2 844 998 B1

(12) EUROPEAN PATENT SPECIFICATION

(45) Date of publication and mention of the grant of the patent: **06.04.2016 Bulletin 2016/14**

(21) Application number: **12799194.1**

(22) Date of filing: **12.12.2012**

(51) Int Cl.: ***G01N 33/00*** *(2006.01)* ***G01R 31/12*** *(2006.01)* ***H01H 33/56*** *(2006.01)*

(86) International application number: **PCT/EP2012/075209**

(87) International publication number: **WO 2013/087684 (20.06.2013 Gazette 2013/25)**

# (54) METHOD AND DEVICE FOR DETERMINING AN OPERATING PARAMETER OF A FLUID INSULATED ELECTRICAL APPARATUS

VERFAHREN UND VORRICHTUNG ZUR BESTIMMUNG EINES BETRIEBSPARAMETERS EINER FLÜSSIGKEITSISOLIERTEN ELEKTRISCHEN VORRICHTUNG

PROCÉDÉ ET DISPOSITIF POUR DÉTERMINER UN PARAMÈTRE DE FONCTIONNEMENT D'UN APPAREIL ÉLECTRIQUE ISOLÉ PAR FLUIDE

(84) Designated Contracting States: **AL AT BE BG CH CY CZ DE DK EE ES FI FR GB GR HR HU IE IS IT LI LT LU LV MC MK MT NL NO PL PT RO RS SE SI SK SM TR**

(30) Priority: **13.12.2011 PCT/EP2011/072515**
**04.09.2012 PCT/EP2012/067217**

(43) Date of publication of application: **11.03.2015 Bulletin 2015/11**

(73) Proprietor: **ABB Technology AG**
**8050 Zürich (CH)**

(72) Inventors:
- **KRAMER, Axel**
  **CH-5430 Wettingen (CH)**
- **PAUL, Thomas Alfred**
  **CH-8820 Wädenswill (CH)**
- **MAHDIZADEH, Navid**
  **CH-5400 Baden (CH)**
- **RANJAN, Nitesh**
  **CH-5430 Wettingen (CH)**

(74) Representative: **ABB Patent Attorneys**
**C/o ABB Schweiz AG**
**Intellectual Property (CH-LC/IP)**
**Brown Boveri Strasse 6**
**5400 Baden (CH)**

(56) References cited:
**EP-A2- 1 085 635** **JP-A- 2001 086 611**
**JP-A- 2010 021 263** **US-A1- 2007 221 626**
**US-B1- 6 276 190**

- **ANONYMOUS: "CBWatch-2 Modular circuit breaker monitoring system", ALSTOM PRODUCT BROCHURE,, 1 September 2010 (2010-09-01), pages 1-4, XP007920955,**

EP 2 844 998 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Technical Field

The present invention relates to methods for deriving at least one operating parameter P of a fluid-insulated electrical apparatus and for operating such an electrical apparatus. Furthermore, it relates to such an electrical apparatus having an analysis and control unit implementing such a method.

### Introduction and Background Art

Dielectric insulation media in liquid and/or gaseous states (i.e. fluids) are widely applied to insulate an electrically active part in a variety of electrical apparatuses, such as switchgears or transformers. For example, the electrically active part in medium or high voltage metal-encapsulated switchgears is arranged in a gas-tight compartment which encloses an insulation gas with a pressure of several bars, which electrically separates the compartment of the apparatus from the electrically active part. In other words, the insulation gas does not allow the passage of electrical current from the electrically active part to the compartment. In order to maintain the safety and functionality of the electrical apparatus, one or more operating parameters of the electrical apparatus which depend on the dielectric breakdown strength $E_{bd}$ of the insulation fluid should be derived.

A commonly used dielectric insulation gas is sulfur hexafluoride ($SF_6$) which exhibits excellent insulation and electric arc extinguishing capabilities. However, $SF_6$ is a strong contributor to the green-house effect and thus has a high global warming potential. Therefore, alternative insulation fluids should be found. Several alternative insulation fluids have been identified. Some of these alternatives comprise multi-component fluid mixtures, i.e. they comprise more than one molecular or atomic species. Because the dielectric breakdown strength $E_{bd}$ of such multi-component fluid mixtures depends, e.g., on the concentration ratio of the mixture components, its derivation becomes more complicated than for single component insulation fluids, however.

US 2002/0095262 A1 and US 7,184,895 B2 describe methods and devices for monitoring the proportion of a component in a gaseous insulation medium consisting of at least two components.

The disclosed methods and devices have the disadvantage, however, that they do not determine the dielectric breakdown strength $E_{bd}$ or an $E_{bd}$-dependent operating parameter, which is a prominent parameter relevant for assessment of an operating state of the gas-insulated electrical apparatus.

### Disclosure of the Invention

Hence it is a general objective of the present invention to provide an improved method for deriving at least one operating parameter P of a fluid-insulated electrical apparatus, wherein the operating parameter P depends on a dielectric breakdown strength $E_{bd}$ of an insulation fluid of the electrical apparatus. Further objectives of the invention are to provide a method for operating such a fluid-insulated electrical apparatus and to provide a fluid-insulated electrical apparatus which is operated by such a method. It is another objective of the invention to provide a computer program element which implements such a method.

These objectives are achieved by the method and devices of the independent claims.

Accordingly, a method for deriving at least one operating parameter P (e.g. indicating an "operational" or "failure" state) of a fluid-insulated electrical apparatus (e.g. of gas-insulated medium or high voltage switchgear) comprises the step of assigning at least three components X, Y, and Z of an insulation fluid of atomic species. Because the dielectric breakdown strength $E_{bd}$ of such multi-component fluid mixtures depends, e.g., on the concentration ratio of the mixture components, its derivation becomes more complicated than for single component insulation fluids, however.

US 2002/0095262 A1 and US 7,184,895 B2 describe methods and devices for monitoring the proportion of a component in a gaseous insulation medium consisting of at least two components.

The disclosed methods and devices have the disadvantage, however, that they do not determine the dielectric breakdown strength $E_{bd}$ or an $E_{bd}$-dependent operating parameter, which is a prominent parameter relevant for assessment of an operating state of the gas-insulated electrical apparatus.

Anonymous. "CBWatch-2 Modular circuit breaker monitoring system", Alstom Product Brochure, Printing Date 2010-09-01, pages 1-4, XP007920955 discloses for circuit breakers filled with $SF_6$ gas or with gas mixtures a system for measuring gas pressure and temperature and for calculating gas density.

US 2007/0221626 A1 discloses a gas-insulated switchgear filled with an arc-extinguishing gas comprising carbon, which switchgear is equipped with a sensor capable of detecting contaminant gases such as CO or $O_3$.

EP 1 085 635 A2 discloses for an electrical equipment filled with a fluid, such as oil, an analysis apparatus for detecting various contaminant gases in the fluid filling.

US 6,276,190 B1 discloses for the gas drilling industry gas quality sensors for measuring relative concentrations

of light and heavy hydrocarbons.

Disclosure of the Invention

Hence it is a general objective of the present invention to provide an improved method for deriving at least one operating parameter P of a fluid-insulated electrical apparatus, wherein the operating parameter P depends on a dielectric breakdown strength $E_{bd}$ of an insulation fluid of the electrical apparatus. Further objectives of the invention are to provide a method for operating such a fluid-insulated electrical apparatus and to provide a fluid-insulated electrical apparatus which is operated by such a method. It is another objective of the invention to provide a computer program element which implements such a method.

These objectives are achieved by the method and devices of the independent claims.

Accordingly, a method for deriving at least one operating parameter P (e.g. indicating an "operational" or "failure" state) of a fluid-insulated electrical apparatus (e.g. of gas-insulated medium or high voltage switchgear) comprises the step of assigning at least three components X, Y, and Z of an insulation fluid of the electrical apparatus to at least a first component group A and to at least a second component group B. The operating parameter P is dependent on a dielectric break-down strength $E_{bd}$ (e.g. an insulation strength) of the insulation fluid. As stated above, the insulation fluid of the electrical apparatus comprises at least three components X, Y, and Z with respective component concentrations $c(X)=c_X$, $c(Y)=c_Y$, and $c(Z)=c_Z$. The first component group A has a group concentration $c_A$ and the second component group B has a group concentration $c_B$. Furthermore, at least one of the component groups A and B comprises at least two of the components X, Y, and Z. In other words, either at least the first component group A comprises at least two of the components X, Y, and Z, or at least the second component group B comprises at least two of the components X, Y, and Z. As an example, the first component group A can comprise the components X and Y and the second component group can comprise the component Z.

The method further comprises the method element of determining at least one quantity of the insulation fluid (e.g. a pressure, a temperature, and/or a density) which is indicative of the group concentration $c_A$ of the first component group A and of the group concentration $c_B$ of the second component group B. The term "indicative" in this respect means that the group concentrations $c_A$ and $c_B$ of the first and second component groups A and B are derivable using the at least one quantity. Optionally, a plurality of such quantities can be determined from the insulation fluid.

Specifically, the method comprises the method element of measuring a plurality of measurement variables (e.g. indicative of the pressure P and/or the temperature T and/or the density $\rho$ of the insulation fluid) by means of at least one sensor. Then, the at least one quantity which is indicative of the group concentrations $c_A$ and $c_B$ of the first and second component groups A and B is determined using these measurement variables. Thus, by measuring the measurement variable or variables, the group concentrations $c_A$ and $c_B$ of the first and second component groups A and B are easier to determine.

Then, the operating parameter P of the fluid-insulated electrical apparatus is derived using the at least one quantity or - alternatively or in addition - the dielectric break-down strength $E_{bd}$ of the insulation fluid is derived using the group concentrations $c_A$ and $c_B$ themselves. Thus, the operating parameter P which is dependent on the dielectric breakdown strength $E_{bd}$ of the insulation fluid of the electrical apparatus can be derived using the at least one quantity which is indicative of the group concentrations $c_A$ and $c_B$. By grouping at least two components into one component group, the number of unknowns is reduced which, e.g., enables the derivation of the operating parameter P from a smaller number of the quantities.

In embodiments, the at least three components X, Y, and Z are assigned to the at least two component groups A and B in such a way that a weighted average value $M_A$ of a molecular mass of the component or components in the first component group A differs from a weighted average value $M_B$ of a molecular mass of the component or components in the second component group B. The term "weighted average value of a molecular mass" relates to an average value of the molecular masses of the respective components (in one component group) which is weighted by their relative concentrations. Thus, the components X, Y, and Z can be assigned to the first and second component groups based on their molecular masses. As an example, for a mixture of 80% nitrogen $N_2$ with a molecular mass of 28 g/mol and 20% oxygen $O_2$ with a molecular mass of 32 g/mol in component group A, a weighted average value of the molecular mass of $M_A$ = 0.2 * 32 g/mol + 0.8 * 28 g/mol = 28.8 g/mol results. If the second component group B comprises, e.g., only one component "perfluoroketone C6" (see definition below) with a molecular mass of M(C6) = 316 g/mol, the weighted average value of the molecular mass $M_B$ = 316 g/mol for this component group B is equal to the molecular mass of the one component.

In embodiments, an absolute value $|M_A-M_B|$ of the difference between the weighted average values $M_A-M_B$ of the molecular masses of the components X, Y, and Z *between* the first and second component groups A and B is larger than weighted statistical spreads $\sigma_{M,A}$ and $\sigma_{M,B}$ of the molecular masses of the components X, Y, and Z *within* the first and second component groups A and B. In other words, the absolute "distance" between the component groups A and B in terms of weighted average molecular masses (distance with regard to an absolute value of the difference between

the respective weighted average values of the single component groups, see Fig. 2) is larger than a "distribution width" (in a statistical sense, e.g. a standard deviation or a weighted standard deviation of the distribution of the components' values) of the molecular masses of the single components within the component groups A and B (distribution width with regard to a statistical width of the distribution). For the above example - as stated above - $M_A$ equals to 28.8 g/mol for an 80%:20% $N_2$:$O_2$ mixture in component group A. Furthermore, $M_B$, e.g., equals to 316 g/mol for a single component "perfluoroketone C6" (see definition below) in the component group B. Then, $|M_A-M_B|$ = 287.2 g/mol. An (unweighted) standard deviation in component group A is $\sigma_{M,A}$ = 2.83 g/mol, whereas a weighted standard deviation would be $\sigma_{M,A}$ = 2.26g/mol. An (unweighted and weighted) standard deviation in component group B is $\sigma_{M,B}$ = 0 (only one component!) by definition. Therefore, the statistical spreads $\sigma_{M,A}$ and $\sigma_{M,B}$ are both smaller than $|M_A-M_B|$. Thus, the component groups A and B can be populated with the components X, Y, and Z based on similar molecular masses.

In other embodiments, an absolute value $|M_A-M_B|$ of the difference between the weighted average values $M_A$-$M_B$ of the molecular masses of the components X, Y, and Z between the first and second component groups A and B is larger than 20 g/mol, preferably larger than 50 g/mol, and more preferably larger than 100 g/mol. This has the advantage that the component groups A and B are separated from each other in terms of the average molecular masses of their respective components.

In other embodiments of the method, the at least three components X, Y, and Z are assigned to the at least two component groups A and B in such a way that a weighted average value $E_{crit,A}$ of a critical field strength of the component or components in the first component group A differs from a weighted average value $E_{crit,B}$ of a critical field strength of the component or components in the second component group B. The term "critical field strength" herein relates to a component or component group specific quantity which is a (statistical) measure of a component or group concentration normalized electrical field that the component or component group of the insulation fluid can maintain without losing its insulating (dielectric) properties and beyond which the component or component group loses these insulating properties resulting in electrical breakdown. In other words, the "critical field strength" describes an upper threshold for a stable state of dielectric insulation of the respective component or component group. Thus, the components X, Y, and Z can be assigned to the first and second component groups based on their critical field strengths.

In embodiments, an absolute value $|E_{crit,A}-E_{crit,B}|$ of the difference between the weighted average values $E_{crit,A}$-$E_{crit,B}$ of the critical field strengths of the components X, Y, and Z *between* the first and second component groups A and B is larger than weighted statistical spreads $\sigma_{Ecrit,A}$ and $\sigma_{Ecrit,B}$ of the critical field strengths of the components X, Y, and Z *within* the first and second component groups A and B. In other words, the absolute "distance" between the component groups A and B in terms of weighted average critical field strengths (distance with regard to an absolute value of the difference between the respective weighted average values in the component groups) is larger than a "distribution width" (in a statistical sense, e.g. a standard deviation or a weighted standard deviation of the distribution of the components' values) of the critical field strengths of the single components within the component groups A and B (distribution width with regard to a statistical width of the distribution). Thus, the component groups A and B can be populated with the components X, Y, and Z based on similar critical field strengths.

In other embodiments of the method, the second component group B comprises at least one of the components selected from the group consisting of:

- sulfur hexafluoride,
- partially or fully fluorinated ethers, in particular hydrofluoroethers, hydrofluoro monoethers, hydrofluoro monoethers containing at least 3 carbon atoms, perfluoro monoethers, or perfluoro monoethers containing at least 4 carbon atoms,
- partially or fully fluorinated ketones, in particular hydrofluoro monoketones, perfluoro monoketones, perfluoro monoketones comprising at least 5 carbon atoms, or perfluoro monoketones comprising exactly 5 or 6 or 7 or 8 carbon atoms, and
- mixtures thereof.

The first component group A comprises at least one of the components selected from the group consisting of:

- nitrogen,
- oxygen,
- carbon dioxide,
- nitric oxide,
- nitrogen dioxide,
- nitrous oxide,
- argon,
- methanes, in particular partially or fully halogenated methanes, in particular tetrafluoromethane or trifluoroiodomethane,
- air, in particular technical air or synthetic air, and

- mixtures thereof.

Thus, an improved insulation performance can be achieved for the insulation fluid of the electrical apparatus.

In embodiments, the second component group B comprises at least one component selected from the group consisting of:

- cyclic and/or aliphatic fluoropentanones, preferably cyclic and/or aliphatic perfluoropentanones, more preferably 1,1,1,3,4,4,4-heptafluoro-3-(tri-fluoromethyl)butan-2-one,
- cyclic and/or aliphatic fluorohexanones, preferably cyclic and/or aliphatic perfluorohexanones, more preferably 1,1,1,2,4,4,5,5,5-nonafluoro-4-(trifluoromethyl)pentan-3-one,
- cyclic and/or aliphatic fluoroheptanones, preferably cyclic and/or aliphatic perfluoroheptanones,
- sulfur hexafluoride, and
- hydrofluoroethers.

Thus, an improved insulation performance can be achieved for the insulation fluid of the electrical apparatus.

In other embodiments, the first component group A comprises:

the components nitrogen and oxygen with relative partial pressures between $p(N_2)/(p(O_2)+p(N_2))=0.7$, $p(O_2)/(p(O_2)+p(N_2))=0.3$ and $p(N_2)/(P(O_2)+p(N_2))=0.95$, $p(O_2)/(p(O_2)+ p(N_2))=0.05$, or
the components carbon dioxide and oxygen with relative partial pressures between $p(CO_2)/(p(O_2)+ p(CO_2))=0.6$, $P(O_2)/ (p(O_2)+(CO_2))=0.4$ and $p(CO_2)/(p(O_2))+ p(CO_2))=0.99$, $p(O_2)/ (p(O_2)+ p(CO_2))=0.01$, or
the components carbon dioxide and nitrogen with relative partial pressures between $p(CO_2)/(p(N_2)+ p(CO_2))=0.1$, $p(N_2)/(p(N_2)+p(CO_2))=0.9$ and $p(CO_2)/(p(N_2)+ p(CO_2))=0.9$, $p(N_2)/(p(N_2)+p(CO_2))=0.1$.

The second component group B comprises at least one of the components of the group consisting of:

1,1,1,3,4,4,4-heptafluoro-3-(tri-fluoromethyl)butan-2-one with a partial pressure between 0.1 bar and 0.7 bar at a temperature of 20°C,
1,1,1,2,4,4,5,5,5-nonafluoro-4-(trifluoromethyl)pentan-3-one with a partial pressure between 0.01 bar and 0.3 bar at a temperature of 20°C,
sulfur hexafluoride with a partial pressure between 0.1 bar and 2 bar at a temperature of 20°C, and
one or more hydrofluoroethers with a partial pressure between 0.2 bar and 1 bar at a temperature of 20°C.

Thus, an improved insulation performance can be achieved for the insulation fluid of the electrical apparatus.

In other embodiments, the first component group A comprises:

the components nitrogen and oxygen with relative partial pressures between $p(N_2)/(p(O_2)+p(N_2))=0.75$, $p(O_2)/(p(O_2)+ p(N_2))=0.25$ and $p(N_2)/(p(O_2)+p(N_2))=0.90$, $p(O_2)/(p(O_2)+ p(N_2))=0.10$.

The second component group B comprises the component 1,1,1,3,4,4,4-heptafluoro-3-(tri-fluoromethyl) butan-2-one with a partial pressure between 0.25 bar and 0.5 bar and/or the component 1,1,1,2,4,4,5,5,5-nona-fluoro-4-(tri-fluoromethyl) pentan-3-one with a partial pressure between 0.02 bar and 0.3 bar at a temperature of 20°C.

Thus, an improved insulation performance can be achieved for the insulation fluid of the electrical apparatus.

In other embodiments of the method, the dielectric breakdown strength $E_{bd}$ of the insulation fluid is derivable using a plurality of the component concentrations $c_X$, $c_Y$, and $c_Z$ of the components X, Y, and Z of the insulation fluid. $E_{bd}$ can be derived according to

$$E_{bd} = S(c_X, c_Y, c_Z, \ldots) \sum_{i=X,Y,Z,\ldots} c_i E_{crit,i}$$

with $c_X$, $c_Y$, and $c_Z$ being the component concentrations of the components X, Y, and Z; with $E_{crit,X}$, $E_{crit,Y}$, and $E_{crit,Z}$ being component-specific critical field strengths of the components X, Y, and Z (i.e. the critical field strengths of the single components); with $S(c_X, c_Y, c_Z)$ being a component specific synergy parameter which, e.g., can also be electrode-geometry and electrode-surface-roughness dependent; and with i being an index for the components X, Y, and Z.

The synergy parameter $S(c_X, c_Y, c_Z)$ is a component and component-concentration dependent parameter that describes the amount of enhancement or reduction of the dielectric breakdown strength $E_{bd}$ of the insulation fluid over a concentration weighted average dielectric breakdown strength as expected from a linear combination of the concentration weighted critical field strengths $E_{crit,X}$, $E_{crit,Y}$, and $E_{crit,Z}$ of the single components X, Y, and Z. This enhancement or reduction is due to complementary properties and/or interactions of the molecules of the single components X, Y, and Z in slowing down and/or attaching free electrons present in the insulation fluid mixture. One or more possible combinations of the components X, Y, and Z can have - at least for certain combinations of the component concentrations $c_X$, $c_Y$, and $c_Z$ - a synergy parameter $S(c_X, c_Y, c_Z) > 1$. For example, all components in the first component group A can show nonlinear enhancement (i.e. $S(c_X, c_Y, c_Z) > 1$, in particular > 1.20) of the dielectric breakdown strength $E_{bd}$ of the insulation fluid with at least one component in the second component group B at least for certain combinations of the component concentrations $c_X$, $c_Y$, and $c_Z$.

Then, the components X, Y, and Z and/or their respective component concentrations $c_X$, $c_Y$, and $c_Z$ are selected such that the synergy parameter $S(c_X, c_Y, c_Z)$ is greater than 1 (for at least one combination of the component concentrations $c_X$, $c_Y$, and $c_Z$). This has the advantage that improved dielectric breakdown strength $E_{bd}$ of the insulation fluid is achieved while a derivation of $E_{bd}$ is simplified.

In other embodiments of the method, the first component group A comprises the components X and Y and the second component group B at least comprises the component Z. Then, a component-group-specific critical field strength $E_{crit,A}$ for the first component group A and/or a component-group-specific critical field strength $E_{crit,B}$ for the second component group B can be derived according to

$$E_{crit,A} = S_A(c_X, c_Y) \sum_{i=X,Y} c_i E_{crit,i}$$

and/or

$$E_{crit,B} = S_B(c_Z, \ldots) \sum_{i=Z,\ldots} c_i E_{crit,i}$$

with $c_X$, $c_Y$, and $c_Z$ being the component concentrations of the components X, Y, and Z; with $E_{crit,X}$, $E_{crit,Y}$, and $E_{crit,Z}$ being component-specific critical field strengths of the components X, Y, and Z; with $S_A(c_X, c_Y)$ and $S_B(c_Z,...)$ being intra-component group synergy parameters of the component groups A and B; and with i being an index for the components X and Y for component group A and for at least (hence the dots) the component Z for component group B. Again, the intra-component group synergy parameters $S_A(c_X, c_Y)$ and $S_B(c_Z,...)$ are partial-pressure-dependent parameters that describe the amount of enhancement or reduction of the component-group-specific critical field strength $E_{crit,A}$ and/or $E_{crit,B}$ of the component groups A and B over average critical field strengths as expected from the critical field strengths $E_{crit,X}$, $E_{crit,Y}$, and $E_{crit,Z}$ of the single components X, Y, and Z in the respective component groups A and/or B.

This has the advantage that component-group-specific critical field strength $E_{crit,A}$ and/or $E_{crit,B}$ of the component groups A and B are easier to derive.

In other embodiments, the intra-component group synergy parameters $S_A(c_X, c_Y)$ and $S_B(c_Z,...)$ are (e.g. within $\pm$10%) equal to 1 for one or more or all combinations of the component concentrations $c_X$ and $c_Y$ and/or $c_Z$. In other words, the component-group-specific critical field strength $E_{crit,A}$ and/or $E_{crit,B}$ within the component groups A and B are not (considerably) enhanced over the component-specific critical field strengths $E_{crit,X}$, $E_{crit,Y}$, and $E_{crit,Z}$. This is achieved by selecting the components X, Y, and Z and/or their respective component concentrations $c_X$, $c_Y$, and $c_Z$ accordingly.

Thus, the operating parameter P of the electrical apparatus becomes easier to derive, because component group specific parameters like $E_{crit,A}$ and/or $E_{crit,B}$ can be used.

In other embodiments, the method further comprises the method element of deriving a dielectric break-down strength $E_{bd}$ of the insulation fluid according to

$$E_{bd} = S(c_A, c_B) \sum_{i=A,B} c_i E_{crit,i}$$

with $E_{crit,A}$ and $E_{crit,B}$ being component-group-specific critical field strengths of the component groups A and B (as, e.g., derived above or from a prestored table in a computer memory); with $c_A$ and $c_B$ being the group concentrations of the component groups A and B; with $S(c_A, c_B)$ being an inter-component group synergy parameter; and with i being an index for the component groups A and B. The inter-component group synergy parameter $S(c_A, c_B)$ describes the amount of enhancement or reduction of the dielectric breakdown strength $E_{bd}$ of the insulation fluid over a group concentration weighted average of the component-group-specific critical field strengths $E_{crit,A}$ and $E_{crit,B}$.

This has the advantage that the operating parameter P of the electrical apparatus that depends on the dielectric

breakdown strength $E_{bd}$ becomes easier to derive because component group specific parameters like $c_A$, $c_B$, $E_{crit,A}$ and $E_{crit,B}$ can be used.

In other embodiments, the inter-component group synergy parameter $S(c_A, c_B)$ is greater than 1, in particular > 1.20, for at least one combination of the group concentrations $c_A$ and $c_B$ of the first and second component groups A and B. This is achieved by selecting the components X, Y, and Z and/or their respective component concentrations $c_X$, $c_Y$, and $c_Z$ accordingly. This has the advantage that an improved dielectric breakdown strength $E_{bd}$ of the insulation fluid is achieved due to the nonlinear enhancement of the dielectric breakdown strength $E_{bd}$.

In other embodiments, the method further comprises the method element of deriving the group concentrations $c_A$ and $c_B$ of the component groups A and B (and additionally or alternatively the component concentrations $c_X$, $c_Y$, and $c_Z$ of the components X, Y, and Z) using the above mentioned measurement variables. This is done by using at least one relating equation, e.g. an equation of state (i.e. a "thermodynamic equation describing the state of matter under a given set of physical conditions", from http://en.wikipedia.org/wiki/Equation_of_state as accessed on Nov 16, 2011). The same or a different relating equation can be used for each of the component groups A and B (and/or for each of the components X, Y, and Z). Thus, a suitable relating equation can be used for each component group and/or component.

In other embodiments, the relating equation/equations is or are selected from the group consisting of:

- the ideal gas law, i.e. $pV = nRT$ with p being an absolute pressure, V being a volume, n being a number of molecules (usually expressed in moles), R being the ideal gas constant, and T being an absolute temperature,
- the van-der-Waals equation of state, i.e. $(p+a/V_m^2)\ (V_m-b)=RT$ with $V_m$ being a molar volume and a, b being substance-specific parameters for the respective component (in particular, a and b can also be derived as effective parameters for a specific insulation fluid mixture),
- the virial equation of state, i.e. $pV_m/(RT) = 1 + B(T)/V_m + C(T)/V_m^2 + D(T)/V_m^3 + ...$ with B(T), C(T), D(T), ... being temperature-dependent terms that correspond to interactions between molecules,
- the Beattie-Bridgeman equation of state, i.e. $p = R_uT/(\nu^2)(1-c/(\nu T^3))(\nu+B)-A/(\nu^2)$ with $A = A_0(1-a/\nu)$, $B = B_0(1-b/\nu)$, $R_u$ being a gas constant in the form $R_u = 8.314$ kPa $m^3$/(kmol K), $\nu$ being a molar volume, and a, b, c, $A_0$, and $B_0$ being substance-specific parameters for the respective component (in particular, again a and b can also be derived as effective parameters for a specific insulation fluid mixture), and
- the Peng-Robinson equation of state, i.e. $p = RT/(V_m-b) - a(T)/(V_m(V_m+b) + b(V_m-b))$ with a(T) and b being empirical parameters.

When a relating equation other than the ideal gas law is used, the behavior of a gas can be better predicted than with the ideal gas law alone and the prediction can be extended to liquids. This is possible by putting in terms to describe attractions and repulsions between molecules.

In other embodiments, at least three measurement variables are measured by means of at least one sensor. One or more relating equation (s) is or are used to derive the group concentrations $c_A$ and $c_B$ of the component groups A and B using the measurement variables. The relating equation(s) is or are functions of at least one weighted average value of a component-specific parameter, in particular of a molecular mass, for the first and second component groups A and B. This has the advantage that the number of unknowns is reduced which, e.g., enables the derivation of the operating parameter P from a smaller number of measurement variables.

Exemplary measurement variables are at least indicative of a pressure (p) and a temperature (T) of the insulation fluid. Thus, a determination of the at least one quantity which is indicative of the group concentrations $c_A$ and $c_B$ of the first and second component groups A and B is simplified.

In embodiments, the measurement variables are at least indicative of the pressure (p), the temperature (T), and a density ($\rho$) of the insulation fluid. Thus, a determination of the at least one quantity which is indicative of the group concentrations $c_A$ and $c_B$ of the first and second component groups A and B is simplified.

Other exemplary measurement variables are additionally indicative of at least one element of the group consisting of a thermal conductivity ($\lambda$), a viscosity ($\eta$), and a speed of sound ($c_S$) of or in the insulation fluid. Thus, a determination of the at least one quantity which is indicative of the group concentrations $c_A$ and $c_B$ of the first and second component groups A and B is simplified.

In other embodiments of the method, a ratio (e.g. $c_X/c_Y$) of the component concentrations (e.g. $c_X$ and $c_Y$) of the components (e.g. X and Y) in each component group (e.g. component group A in this example) is constant (or varies less than $\pm$10%, preferably less than $\pm$1%) over a period of the application of the method, e.g. 400 days or 4000 days or 10000 days. Advantageously, the method is applied repeatedly, e.g. once or twice a day, over this period. Preferably, the method is intended to be used continuously, e.g. to produce one measurement point every second, such as to derive good averaging statistics and permit an early trend detection.

In other words, preferential leakage of one of the components in a single component group A or B does not (or not to a considerable degree) occur. Or, in other words, the relative composition of all component groups A, B,... remains constant or varies less than the above mentioned value. Thus, a more or less constant composition of the component

groups can be assumed which simplifies the derivation of the operating parameter P of the electrical apparatus.

In embodiments, the operating parameter P of the fluid-insulated electrical apparatus is a value of the dielectric breakdown strength $E_{bd}$ of the insulation fluid itself, an $E_{bd}$-dependent state of an indicator element (e.g. a display element showing the current value of $E_{bd}$), a change over time of the dielectric breakdown strength $E_{bd}$ (e.g. a trend or a time derivative of the value of $E_{bd}$), or a Boolean variable with its variable value being dependent on the dielectric breakdown strength $E_{bd}$ (e.g. for being fed into an LED element indicating "operational" or "failure" depending on the value of $E_{bd}$). Thus, a plurality of $E_{bd}$-depending operating parameters P can be derived.

In other embodiments, the insulation fluid comprises at least four components X, Y, Z, and ZZ with component concentrations $c_X$, $c_Y$, $c_Z$, and $c_{ZZ}$. The method comprises the method element of assigning the four or more components to three or more (hence the "dots") component groups A, B, and C with group concentrations $c_A$, $c_B$, and $c_C$. At least one of the component groups comprises two or more of the components. The method comprises the further step of determining at least one quantity of the insulation fluid which is indicative of all group concentrations, i.e. one or more quantity/quantities from which all group concentrations can be derived. The method comprises the further method element of deriving the dielectric breakdown strength $E_{bd}$ of the insulation fluid according to

$$E_{bd} = S(c_A, c_B, c_C, \ldots) \sum_{i=A,B,C,\ldots} c_i E_{crit,i}$$

with $E_{crit,i}$ for i = A, B, C,... being component-group-specific critical field strengths of the component groups; with $c_i$ for i = A, B, C,... being the group concentrations of the component groups; with $S(c_A, c_B, c_C, \ldots)$ being an inter-component group synergy parameter; and with i being an index for the component groups A, B, C, ....

As another aspect of the invention, a method for operating a fluid-insulated electrical apparatus such as gas-insulated medium or high voltage switchgear is disclosed using a method as described above. As it is apparent from the description herein, the term "method for *operating* a fluid-insulated electrical apparatus" relates to a method for making the electrical apparatus available and/or maintaining the operation (i.e. keeping the electrical apparatus in an operative condition) of the electrical apparatus. This is achieved by deriving the at least one $E_{bd}$-dependent operating parameter P using the at least one quantity which is indicative of the group concentration $c_A$ of the first component group A and of the group concentration $c_B$ of the second component group B. Thus, the safe operation of the electrical apparatus can be maintained.

In other embodiments of the operating method, the method further comprises a method element of actively or passively circulating the insulation fluid for homogenizing a density and/or a mixture of the first and/or the second and/or the third components X, Y, and/or Z. This is, e.g., achieved by means of a fan or by convection. This step is preferably carried out before the step of determining the at least one quantity of the insulation fluid. Thus, a more meaningful determination of the quantity is enabled.

In other embodiments, the method further comprises at least one method element of the group consisting of:

- Increasing at least one of the component concentrations $c_X$, $c_Y$, and/or $c_Z$ of the components X, Y, and/or Z of the insulation fluid. This can, e.g., be achieved by means of injecting an amount of at least one of the components X, Y, and/or Z from a component reservoir into a compartment of the electrical apparatus. Thus, the respective component(s) component of the insulation fluid in the compartment can be replenished on demand which minimizes downtime of the electrical apparatus in case of a malfunction;
- Reducing at least one of the component concentrations $c_X$, $c_Y$, and/or $c_Z$ of the components X, Y, and/or Z of the insulation fluid. Thus, an excess amount of the respective component(s) of the insulation fluid can be removed from the compartment of the electrical apparatus;
- Reducing a concentration of at least one contaminant (i.e. an unwanted substance in the insulation fluid) in the insulation fluid, in particular by means of a filter adsorbing the contaminant. Thus, unwanted substances which can lower the insulation performance can be removed from the insulation fluid;
- At least partially evaporating a condensed amount of at least one of the components X, Y, and/or Z of the insulation fluid. This can, e.g., be achieved by means of a heater located in the lower part of the compartment. Thus, unwanted insulation-fluid-component-condensation which can occur, e.g., at low ambient temperatures, can be effectively counteracted.
- Condensing an amount of at least one of the components X, Y, and/or Z of the insulation fluid, in particular by means of a cooler. Thus, the gaseous amount of the condensed component can be reduced.

As a consequence of carrying out one or more of the above method elements or steps, a suitable mixing ratio for the insulation fluid can be more easily maintained. This or these step(s) are preferably selected in dependence of or using the operating parameter P in which the electrical apparatus is in.

As another aspect of the invention, a fluid-insulated electrical apparatus such as gas-insulated medium or high voltage switchgear is disclosed. The fluid-insulated electrical apparatus comprises an insulation fluid which comprises at least three components X, Y, and Z. Furthermore, the electrical apparatus comprises a control and analysis unit which is adapted to carry out the method elements (i.e. steps in any suitable time order) of a method as described above. Thus, the safe operation of the electrical apparatus can be maintained. The control and analysis unit can advantageously comprise a memory which is adapted to store a plurality of predefined values (e.g. a lookup table), such as component-specific critical field strengths $E_{crit,X}$, $E_{crit,Y}$, and $E_{crit,Z}$, and/or component-group-specific critical field strengths $E_{crit,A}$ and $E_{crit,B}$ and/or component-specific synergy parameters $S(c_X, c_Y, c_Z)$ and/or intra-component group synergy parameters $S_A(c_X, c_Y)$ and $S_B(c_Z, ...)$ and/or inter-component group synergy parameters $S(c_A, c_B)$ for different combinations of components X, Y, and Z and/or component concentrations $c_X$, $c_Y$, $c_Z$ and/or group concentrations $c_A$, $c_B$. In embodiments, the control and analysis unit can be adapted to issue a signal (e.g. to issue a warning signal to an operator and/or a computer readable signal) and/or to shutdown the electrical apparatus, when the electrical apparatus enters and/or leaves a predefined operating state as described by the operating parameter P. As an example, the electrical apparatus can be shut down and an alert signal can be issued when the dielectric breakdown strength $E_{bd}$ of the insulation fluid decreases below a threshold.

As another aspect of the invention, a computer program element comprising computer program code means for, when executed by a processing unit, implementing a method as described above is disclosed. This enables the integration of a method as described above into an electrical apparatus comprising a control and analysis unit.

## Brief Description of the Drawings

The invention and its embodiments will be more fully appreciated by reference to the following detailed description of presently preferred but nonetheless illustrative embodiments in accordance with the present invention when taken in conjunction with the accompanying drawings.

Fig. 1 shows a schematic of a fluid-insulated electrical apparatus,

Fig. 2 shows a schematic of an assignment of three components X, Y, and Z to two component groups A and B,

Fig. 3 shows an inter-component group synergy parameter $S(c_A, c_B)$ as a function of the total pressure p with fixed partial pressures $p_B$ for different component groups B, and

Fig. 4 shows an inter-component group synergy parameter $S(c_A, c_B)$ as a function of a mole-fraction of the perfluoroketones C5 or C6 (group B) in air (group A).

## Modes for Carrying Out the Invention

*Description of the Figures:*

Fig. 1 shows a schematic of a fluid-insulated electrical apparatus 1, i.e. here a gas insulated switch 1. An electrically active part 60 of the fluid-insulated apparatus 1 is arranged in a gas-tight compartment 50 which encloses an insulation fluid 10 for preventing the passage of electrical current from the electrically active part 60 to the compartment 50. The insulation fluid 10 is an insulation gas 10 comprising the component X which is nitrogen $N_2$ with a partial pressure $p_X=p(N_2)=5.29$ bar, the component Y which is oxygen $O_2$ with a partial pressure $p_Y=p(O_2)=1.41$ bar and the component Z which is "perfluoroketone C5" (see definition below) with a partial pressure $p_Z=p(C5)=0.3$ bar at a temperature of 20°C. The total filling pressure $p=p_X+p_Y+p_Z$ at filling time is $p=p_X+p_Y+p_Z=7$ bar, the total volume of the gas-tight compartment 50 (filling volume of the insulation gas 10) is $V=2\ m^3$. As an option, additionally or as replacement for component Z, a component "perfluoroketone C6" with a partial pressure p(C6) = 0.1 bar and/or a component "perfluoroketone C7" can be added to the insulation gas 10 (not shown in Fig. 1). The components X and Y are assigned to the component group A and the component Z is assigned to the component group B (see figure 2 below). Thus, a weighted average value $M_A$ of the molecular masses of the two components X and Y in the first component group A differs from a weighted average value $M_B$ of the molecular mass of the component in the second component group B: Here, $M_A$ = 28.8 g/mol and $M_B$ = 266 g/mol. The measurement variables pressure p, temperature T, and density $\rho$ (e.g. WO 2010/043268 A1 discloses a suitable density sensor device for this purpose) of the insulation fluid 10 mixture are measured by the sensors 30 and electrical signals indicative of these measurement variables are transmitted to the analysis and control unit 40 comprising a processing unit 41 and a memory 42.

As an option, additionally or as a replacement for the density $\rho$ of the insulation gas 10, other suitable measurement variables like thermal conductivity $\lambda$, viscosity $\eta$, and/or speed of sound $c_S$ of or in the insulation gas 10 can be measured by the same or a different sensor device 30 (not shown in Fig. 1). The measurement variables can then be related to the concentration values $c_A$, $c_B$ of the component groups A and B of the insulation fluid 10, e.g. by using the following relating equation (if pressure p, temperature T, and speed of sound $c_S$ are measured):

$$c_S = \sqrt{\frac{RT(c_A c_{pA} + c_B c_{pB})}{(c_A M_A + c_B M_B)(c_A c_{VA} + c_B c_{VB})}}$$

with $c_A$ and $c_B$ being the desired group concentration values in mole fractions of the component groups A and B with $c_A+c_B=1$, $c_A=p_A/p$,r and $c_B=p_B/p$, $p_A$ and $p_B$ being partial pressures of the component groups A and B, R being the ideal gas constant, $M_A$ and $M_B$ being (averaged) molecular masses of the component groups A and B, and $c_{pA}$, $c_{pB}$, $c_{VA}$, and $c_{VB}$ being known specific heat values of the component groups A and B at constant pressures and constant volumes, respectively.

If pressure p, temperature T, and viscosity $\eta$ are measured, the following relating equation can, e.g., be used:

$$\eta(T) = \frac{c_A \eta_A(T)}{c_A \Phi_{AA} + c_B \Phi_{AB}} + \frac{c_B \eta_B(T)}{c_B \Phi_{BB} + c_A \Phi_{BA}}$$

with

$$\Phi_{ij}(T) = \frac{1}{2\sqrt{2}} \left(1 + \frac{M_i}{M_j}\right)^{-1/2} \left[1 + \left(\frac{\eta_i(T)}{\eta_j(T)}\right)^{1/2} \left(\frac{M_j}{M_i}\right)^{1/4}\right]^2$$

and with i=A, B, with j=A, B, with $c_A$ and $c_B$ being the desired group concentration values in mole fractions of the component groups A and B with $c_A+c_B=1$, $c_A=p_A/p$, and $c_B=p_B/p$, $p_A$ and $p_B$ being partial pressures of the component groups A and B, $\eta_A(T)$ and $\eta_B(T)$ being known temperature dependent viscosities of the component groups A and B, and $M_A$ and $M_B$ being (averaged) molecular masses of the component groups A and B.

If pressure p, temperature T, and thermal conductivity $\lambda$ are measured, the following relating equation can, e.g., be used:

$$\lambda(T) = \frac{c_A \lambda_A(T)}{c_A \Phi_{AA} + c_B \Phi_{AB}} + \frac{c_B \lambda_B(T)}{c_B \Phi_{BB} + c_A \Phi_{BA}}$$

with

$$\Phi_{ij}(T) = \frac{1}{2\sqrt{2}} \left(1 + \frac{M_i}{M_j}\right)^{-1/2} \left[1 + \left(\frac{\eta_i(T)}{\eta_j(T)}\right)^{1/2} \left(\frac{M_j}{M_i}\right)^{1/4}\right]^2$$

and with i=A, B, with j=A, B, with $c_A$ and $c_B$ being the desired concentration values in mole fractions of the component groups A and B with $c_A+c_B=1$, $c_A=p_A/p$, and $c_B=p_B/p$, $p_A$ and $p_B$ being partial pressures of the component groups A and B, $\lambda_A(T)$ and $\lambda_B(T)$ being known temperature dependent thermal conductivities of the component groups A and B, $\eta_A(T)$ and $\eta_B(T)$ being known temperature dependent viscosities of the component groups A and B, and $M_A$ and $M_B$ being (averaged) molecular masses of the component groups A and B.

E.g. US 6,305,212 B1, US 6,272,905 B1, and T. Löfquist et. al: "SPEED OF SOUND MEASUREMENTS IN GAS-MIXTURES AT VARYING COMPOSITION USING AN ULTRASONIC GAS FLOW METER WITH SILICON BASED TRANSDUCERS" (e.g. http://pure.ltu.se/portal/files/60931/artikel.pdf as accessed on 18 Nov 2011) give further examples on how to relate different measurement variables.

In this embodiment, this is not necessary, however, because measurement variables indicative of the pressure p, the temperature T, and the density $\rho$ are measured as discussed above. The analysis and control unit 40 determines the partial pressure $p_A$ of the first component group A and the partial pressure $p_B$ of the second component group B using the following equations:

$$p_{tot} = p_A + p_B \qquad \text{Eq.1}$$

$$\rho_{tot} = \frac{M_A p_A}{RT} + \frac{M_B p_B}{RT} \qquad \text{Eq.2}$$

$$p_A = \frac{\frac{RT}{M_A}\rho_{tot} - \frac{M_B}{M_A}p_{tot}}{\left(1 - \frac{M_B}{M_A}\right)}$$

Eq. 3

$$p_B = \frac{p_{tot} - \frac{RT}{M_A}\rho_{tot}}{\left(1 - \frac{M_B}{M_A}\right)}$$

Eq. 4

with $p_{tot}$ being the (total) pressure p, $\rho_{tot}$ being the (total) density $\rho$, T being the temperature, R being the ideal gas constant, and $M_A$ and $M_B$ being the weighted average values of the molecular masses of the component groups A and B, respectively. Here, the ideal gas law pV=nRT and the equations n=m/M and m=$\rho$V with m being a mass and V being a volume are used for both component groups A and B as an approximation. As an alternative, different relating equations could be used for both component groups A and B as discussed above.

Then, the operating parameter P of the electrical apparatus 1 (which is the dielectric breakdown strength $E_{bd}$ of the insulation fluid 10 in this embodiment) is derived from the group partial pressures $p_A$ and $p_B$ (which are - as it is obvious to a person skilled in the art - directly linked to the group concentrations $c_A$ and $c_B$ via $c_i=p_i/p$, i=A, B), from component-group-specific critical field strengths $E_{crit,A}$ and $E_{crit,B}$, and from the inter-component group synergy parameter $S(c_A, c_B)$ according to the following equation:

$$E_{bd} = S(c_A, c_B) \sum_{i=A,B} c_i E_{crit,i}$$

The component-group-specific critical field strengths $E_{crit,A}$ and $E_{crit,B}$ and the inter-component group synergy parameter $S(c_A, c_B)$ can be prestored in the memory 42 of the analysis and control unit 40. The inter-component group synergy parameter $S(c_A, c_B)$ can be prestored as a lookup-table for a plurality of $c_A$-$c_B$-combinations, interpolation can additionally be used between prestored values. The intra-component group synergy parameters are equal to 1. Thus, - albeit the insulation fluid 10 comprises three components X, Y, and Z - the dielectric breakdown strength $E_{bd}$ of the insulation fluid 10 can more easily be derived from only three measurement variables pressure p, temperature T, and density p. This is possible due to the grouping step as described above.

Whenever the dielectric breakdown strength $E_{bd}$ of the insulation fluid 10 decreases below a threshold, (i.e. the electrical apparatus 1 leaves an "operational" operating state as defined by the parameter P), an alert signal can be issued to a user from the control unit 40 and an emergency shutdown of the electrical switch 1 can be initiated.

Furthermore, optionally, depending on the entered operating state, countermeasures can be taken automatically by the electrical apparatus 1: As an example, if the ambient temperature drops severely and component Z partly condenses in the lower part of the compartment 50, heater 80 can be engaged to evaporate at least a part of the condensed component Z, thus ensuring a sufficient gaseous amount of component Z in the gaseous phase of the insulation fluid

10 in the compartment 50.

As another example, if preferential leakage of components A and B occurs, e.g., due to a very small leak in the compartment 50, an amount of these components can be replenished from a pressurized component reservoir 70, thus minimizing downtime of the electrical apparatus 1.

As yet another example, a filter 90 in the compartment 50 can be used to remove an unwanted substance (i.e. a contaminant of the insulation fluid 10, e.g. due to arcing) from the insulation fluid 10.

Fig. 2 shows a schematic of an assignment of the three components X, Y, and Z of Fig. 1 to the two component groups A and B. The components are assigned to the component groups A and B based on their molecular masses of $M_X$=32 g/mol, $M_Y$=28 g/mol, and $M_Z$=266 g/mol, as described above. Thus, weighted average value of the molecular mass of $M_A$=28.8 g/mol and $M_B$=266 g/mol result. As a result, an absolute value $|M_A-M_B|$ of the difference between the weighted average values $M_A-M_B$ is larger than standard deviations of the distributions of the components' values which are $\sigma_{M,A}$ = 2.33 g/mol and $\sigma_{M,B}$=0 g/mol (unweighted standard deviations). Thus, the components X, Y, and Z are assigned to the first and second component groups A and B based on similar molecular masses. A similar approach could be used for grouping by similar component specific critical field strengths $E_{crit,X}$, $E_{crit,Y}$ and $E_{crit,Z}$.

Grouping the components based on similar molecular masses has two reasons: (1) The closer the molecular masses of grouped components are, the less will undesired leakage rates between these components differ. Therefore, an approximation, that the relative concentrations of these grouped components (i.e. in each component group) remains constant, is better. (2) Some substance-specific and/or empirical parameters of relating equations will be more similar for grouped components of similar molecular masses.

As an effect of the grouping approach, the dielectric breakdown strength $E_{bd}$ of the insulation fluid 10 can more easily be derived from only three measurement variables pressure p, temperature T, and density $\rho$ because group-specific parameters can be used.

Fig. 3 shows the inter-component group synergy parameter $S(c_A, c_B)$ as a function of total pressure $p=p_A+p_B$ with fixed partial pressures $p_B$ for different component groups B. The same relation for relating partial pressures to concentrations as discussed above is used. Specifically, the rectangles refer to a component group B comprising the perfluoroketone C6 with a partial pressure $p_B$=0.1 bar, the diamonds refer to a component group B comprising the perfluoroketone C5 with a partial pressure $p_B$=0.3 bar, and the triangles refer to a component group B comprising the perfluoroketones C5 and C6 with partial pressures $p_{B,C5}$=0.3 bar and $p_{B,C6}$=0.1 bar, i.e., $p_B$=0.4 bar. The component group A of the insulation fluid 10 consists of synthetic air (80 % $N_2$ and 20% $O_2$). The total pressure $p=p_A+p_B$ (x-axis) is varied by adding more and more synthetic air and the inter-component group synergy parameter $S(c_A, c_B)$ (y-axis) is shown for different total pressures p (and hence different partial pressures $p_A$ or concentrations $c_A$, respectively). As it can be seen from the figure, for the C5 (diamonds) and for the mixed C5-C6 (triangles) component groups B, the inter-component group synergy parameter $S(c_A, c_B)$ and hence the dielectric breakdown strength $E_{bd}$ of the insulation fluid 10 increase up to a total pressure of about 2 bar whereas for the C6 (rectangles) component group B, the inter-component group synergy parameter $S(c_A, c_B)$ remains almost constant with increasing total pressure p. Thus, if the partial pressure $p_A$ is increased to a total pressure of about 2 bar for C5 and C5-C6, the dielectric breakdown strength $E_{bd}$ of the insulation fluid is more and more nonlinearly enhanced.

Similar to Fig. 3, Fig. 4 shows an inter-component group synergy parameter $S(c_A, c_B)$ as a function of the mole fraction $c_B/(c_A+c_B)$ of the perfluoroketone C5 or the perfluoroketone C6 which is (one at a time, no mixture in component group B in this embodiment) comprised in component group B. The component group A of the insulation fluid 10 consists of synthetic air (80 % $N_2$ and 20% $O_2$). The mole fraction (x-axis) defines a ratio of number of particles. E.g., a mole fraction of component group B of 0.5 means that half of the molecules in the compartment 50 of the electrical apparatus 1 belong to component group B. The diamonds show experimental values for $S(c_A, c_B)$ whereas the line refers to a fit function for the experimental synergy datapoints of the form $S(c_A, c_B)$=a*exp (-x/x1)-exp(-x/x2)]+b with a=0.37, x1=0.3, x2=0.026, and b=1 being fit parameters and x being the mole fraction $x=c_B/(c_A+c_B)$ of the perfluoroketones C5 or C6 (experimental datapoints for both components are shown) which are - one at a time - comprised in component group B. As it can be seen from the figure, the inter-component group synergy parameter $S(c_A, c_B)$ and hence the achievable dielectric breakdown strength $E_{bd}$ of the insulation fluid 10 increases up to a mole fraction of component group B of about 0.1 and then decreases. Thus, if the mole fraction (or, equivalently, the concentration $c_B$) of component group B is increased to about 0.1 the dielectric breakdown strength $E_{bd}$ of the insulation fluid is maximally nonlinearly enhanced.

*Definitions:*

The term "aliphatic" relates to both "linear aliphatic" and "branched aliphatic".

The term "fluid" relates to "a substance, such as a liquid [and/] or gas, that can flow, has no fixed shape, and offers little resistance to an external stress" (from http://www.thefreedictionary.com/fluid, accessed on 9/11/2011).

The term "weighted average value" of a property N of the components in a component group relates to a statistical average (such as the median or the mean) of the property N of all the components in the component group.

This statistical average is weighted by the concentrations of the components that form the respective component group. If the term "weighted average value" of a property N of a single component that forms a component group is used, the property N of the single component itself is referred to. Similar definitions apply for the statistical spread. In particular, a statistical spread of a property N in a component group consisting of only a single component is 0.

The term "high-voltage" relates to voltages larger than 50 kV.

The term "medium-voltage" relates to voltages larger than 1 kV.

The term "concentration" herein shall define

- a quantity (with units) which is indicative of an amount per volume unit, e.g. a particle number per volume unit, moles per volume unit, or a number density, or
- a number (without units) which is indicative of a ratio such as a mole fraction, a pressure-normalized partial pressure, a volume fraction, a mass fraction, or a density fraction.

The compound class "hydrofluoroethers" relates to specific partially or fully fluorinated ethers as, e.g., available from 3M.

The compound "C5" particularly relates to a partially or fully fluorinated fluoroketone selected from the group consisting of the compounds defined by the following structural formulae in which at least one hydrogen atom, preferably all hydrogen atoms, is/are substituted with a fluorine atom/fluorine atoms:

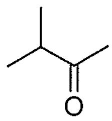 (Ia),

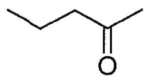 (Ib),

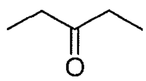 (Ic),

and

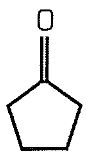 (Id).

The compound "C6" particularly relates to a partially or fully fluorinated fluoroketone selected from the group consisting of the compounds defined by the following structural formulae in which at least one hydrogen atom, preferably all hydrogen atoms, is/are substituted with a fluorine atom/fluorine atoms:

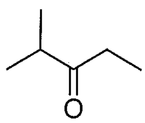 (IIa),

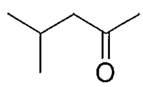 (IIb),

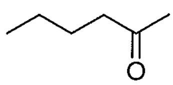 (IIc),

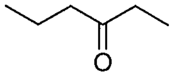 (IId),

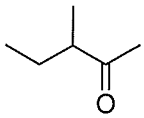 (IIe),

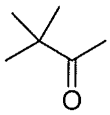 (IIf),

and

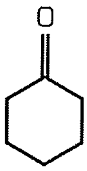 (IIg).

The compound "C7" particularly relates to a partially or fully fluorinated fluoroketone selected from the group consisting of the compounds defined by the following structural formulae in which at least one hydrogen atom, preferably all hydrogen atoms, is/are substituted with a fluorine atom/fluorine atoms:

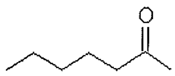 (IIIa),

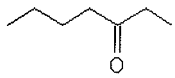 (IIIb),

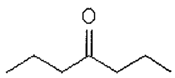 (IIIc),

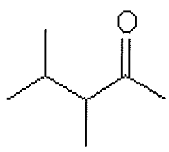 (IIId),

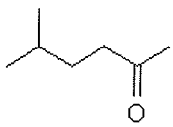 (IIIe),

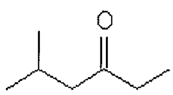 (IIIf),

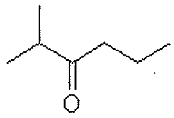 (IIIg),

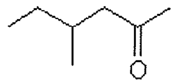 (IIIh),

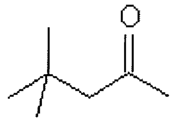 (IIIi),

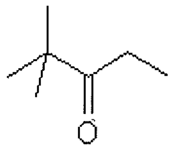 (IIIj),

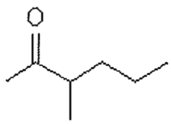 (IIIk),

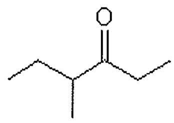 (IIIl),

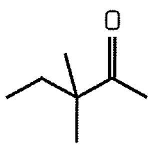 (IIIm),

and

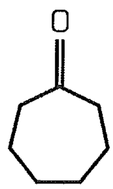 (IIIn).

*Note:*

While there are shown and described presently preferred embodiments of the invention, it is to be distinctly understood that the invention is not limited thereto but may otherwise variously be embodied and practiced within the scope of the following claims. Therefore, terms like "preferred", "advantageous" or the like denote optional features or

embodiments only. Method step generally means method element, i.e. does not imply that the steps shall be executed in the order as they are listed.

This application claims priority from the yet unpublished international patent applications PCT/EP2011/ 072515 and PCT/EP2012/067217, the content of which is hereby enclosed by reference in its entirety.

Reference numbers

**[0094]**

| | |
|---|---|
| 1: | electrical apparatus |
| 10: | insulation fluid |
| A, B: | component groups of the insulation fluid 10 |
| X, Y, Z: | components of the insulation fluid 10 |
| $\rho$, p, T, $\lambda$, $\eta$, $c_S$: | measurement variables |
| 30: | sensors |
| 40: | control and analysis unit |
| 41: | processing unit |
| 42: | memory |
| 50: | gas-tight compartment |
| 60: | electrically active part |
| $c_X$, $c_Y$, $c_Z$: | component concentrations, e.g. expressed in mol/m$^3$ or without units, of components X,Y,Z |
| $c_A$, $c_{B:}$ | group concentrations of component groups A, B |
| $E_{crit,X}$, $E_{crit,Y}$, $E_{crit,Z}$: | component-specific critical field strengths, e.g. expressed in kV/(cm*(mol/m3)) |
| $E_{crit,A}$, $E_{crit,B}$: | component-group-specific critical field strengths, e.g. expressed in kV/(cm*(mol/m$^3$)) |
| $S(c_X, c_Y, c_Z)$: | synergy parameter |
| $S_A(c_X, c_Y)$, $S_B(c_Z,...)$: | intra-component group synergy parameters |
| $S(c_A, c_B)$: | inter-component group synergy parameter |
| Ebd: | dielectric breakdown strength of the insulation fluid 10 of the electrical apparatus 1, e.g. expressed in kV/cm. |
| 70: | component reservoir |
| 80: | heater |
| 90: | filter |

## Claims

1. A method for deriving at least one operating parameter P of a fluid-insulated electrical apparatus (1), which is a gas-insulated medium or high voltage switchgear (1) or a transformer and which comprises an insulation fluid (10) with at least three components X, Y, and Z with component concentrations $c_X$, $c_Y$, and $c_Z$, and
which derived operating parameter P is dependent on a dielectric breakdown strength $E_{bd}$ of the insulation fluid (10) of the electrical apparatus (1) and defines an operational operating state or a failure state of the electrical apparatus (1),
the method comprising the method elements of

   - measuring by means of at least one sensor (30) a plurality of measurement variables ($\rho$, p, T, $\lambda$, $\eta$, $c_S$), wherein the measurement variables ($\rho$, p, T, $\lambda$, $\eta$, $c_S$) are indicative of at least a pressure (p) and a temperature (T) of the insulation fluid (10),
   - assigning the at least three components X, Y, and Z to at least a first component group A with a group concentration $c_A$ and to at least a second component group B with a group concentration $c_B$, wherein at least the first component group A comprises at least two of the components X, Y, and Z or wherein at least the second component group B comprises at least two of the components X, Y, and Z,
   - wherein the at least three components X, Y, and Z are assigned to the at least two component groups A and B in such a way that a weighted average value $M_A$ of a molecular mass of the component or components in the first component group A differs from a weighted average value $M_B$ of a molecular mass of the component or components in the second component group B,
   - deriving the group concentrations $c_A$ and $c_B$ of the component groups A and B by using the measurement variables ($\rho$, p, T, $\lambda$, $\eta$, $c_S$) and at least one relating equation, which is the same or different for each of the component groups A and B, and

- deriving the operating parameter P using the group concentration $c_A$ and the group concentration $c_B$.

2. The method of claim 1, wherein an absolute value $|M_A-M_B|$ of the difference between the weighted average values $M_A-M_B$ of the molecular masses of the components X, Y, and Z between the first and second component groups A and B is larger than weighted statistical spreads $\sigma_{M,A}$ and $\sigma_{M,B}$ of the molecular masses of the components X, Y, and Z within the first and second component groups A and B.

3. The method of claim 2, wherein the absolute value $|M_A-M_B|$ of the difference between the weighted average values $M_A-M_B$ of the molecular masses of the components X, Y, and Z between the first and second component groups A and B is larger than 20 g/mol, preferably larger than 50 g/mol, more preferably larger than 100 g/mol.

4. The method of any of the preceding claims, wherein the at least three components X, Y, and Z are assigned to the at least two component groups A and B in such a way that a weighted average value $E_{crit,A}$ of a critical field strength of the component or components in the first component group A differs from a weighted average value $E_{crit,B}$ of a critical field strength of the component or components in the second component group B.

5. The method of claim 4, wherein an absolute value $|E_{crit,A}-E_{crit,B}|$ of the difference between the weighted average values $E_{crit,A}-E_{crit,B}$ of the critical field strengths of the components X, Y, and Z between the first and second component groups A and B is larger than weighted statistical spreads $\sigma_{Ecrit,A}$ and $\sigma_{Ecrit,B}$ of the critical field strengths of the components X, Y, and Z within the first and second component groups A and B.

6. The method of any of the preceding claims, wherein the second component group B comprises at least one of the components from the group consisting of:

- sulfur hexafluoride,
- partially or fully fluorinated ethers, in particular hydrofluoroethers, hydrofluoro monoethers, hydrofluoro monoethers containing at least 3 carbon atoms, perfluoro monoethers, or perfluoro monoethers containing at least 4 carbon atoms,
- partially or fully fluorinated ketones, in particular hydrofluoro monoketones, perfluoro monoketones, perfluoro monoketones comprising at least 5 carbon atoms, or perfluoro monoketones comprising exactly 5 or 6 or 7 or 8 carbon atoms, and
- mixtures thereof, and

wherein the first component group A comprises at least one of the components from the group consisting of:

- nitrogen,
- oxygen,
- carbon dioxide,
- nitric oxide,
- nitrogen dioxide,
- nitrous oxide,
- argon,
- methanes, in particular partially or fully halogenated methanes, in particular tetrafluoromethane or trifluoroiodomethane,
- air, in particular technical air or synthetic air, and
- mixtures thereof.

7. The method of claim 6, wherein the second component group B comprises at least one component from the group consisting of:

- cyclic and/or aliphatic fluoropentanones, preferably cyclic and/or aliphatic perfluoropentanones, more preferably 1,1,1,3,4,4,4-heptafluoro-3-(tri-fluoromethyl)butan-2-one,
- cyclic and/or aliphatic fluorohexanones, preferably cyclic and/or aliphatic perfluorohexanones, more preferably 1,1,1,2,4,4,5,5,5-nonafluoro-4-(tri-fluoromethyl)pentan-3-one,
- cyclic and/or aliphatic fluoroheptanones, preferably cyclic and/or aliphatic perfluoroheptanones,
- sulfur hexafluoride, and
- hydrofluoroethers.

8. The method of any of the claims 6 to 7, wherein the first component group A comprises:

the components nitrogen and oxygen with relative partial pressures between $p(N_2)/(p(O_2)+p(N_2))=0.7$, $p(O_2)/(p(O_2)+ p(N_2))=0.3$ and $p(N_2)/(p(O_2)+p(N_2))=0.95$, $p(O_2)/(p(O_2)+ p(N_2))=0.05$, or
the components carbon dioxide and oxygen with relative partial pressures between $p(CO_2)/(p(O_2)+ p(CO_2))=0.6$, $p(O_2)/ (p(O_2)+o(CO_2))=0.4$ and $p(CO_2)/(p(O_2)+ p(CO_2))=0.99$, $p(O_2)/ (p(O_2)+ p(CO_2))=0.01$, or
the components carbon dioxide and nitrogen with relative partial pressures between $p(CO_2)/(p(N_2)+ p(CO2))=0.1$, $p(N_2)/(p(N_2)+p(CO_2))=0.9$ and $p(CO_2)/(p(N_2)+ p(CO_2))=0.9$, $p(N_2)/(p(N_2)+p(CO_2))=0.1$, and

wherein the second component group B comprises at least one components of the group consisting of:

1,1,1,3,4,4,4-heptafluoro-3-(tri-fluoromethyl)butan-2-one with a partial pressure between 0.1 bar and 0.7 bar at a temperature of 20°C,
1,1,1,2,4,4,5,5,5-nonafluoro-4-(tri-fluoromethyl)pentan-3-one with a partial pressure between 0.01 bar and 0.3 bar at a temperature of 20°C,
sulfur hexafluoride with a partial pressure between 0.1 bar and 2 bar at a temperature of 20°C, and
one or more hydrofluoroethers with a partial pressure between 0.2 bar and 1 bar at a temperature of 20°C.

9. The method of any of the claims 6 to 8, wherein the first component group A comprises:

the components nitrogen and oxygen with relative partial pressures between $p(N_2)/(p(O_2)+p(N_2))=0.75$, $p(O_2)/(p(O_2)+ p(N_2))=0.25$ and $p(N_2)/(p(O_2)+p(N_2))=0.90$, $p(O_2)/(p(O_2)+ p(N_2))=0.10$, and
wherein the second component group B comprises the component 1,1,1,3,4,4,4-heptafluoro-3-(trifluoromethyl)butan-2-one with a partial pressure between 0.25 bar and 0.5 bar and/or the component 1,1,1,2,4,4,5, 5,5-nona-fluoro-4-(tri-fluoromethyl)pentan-3-one with a partial pressure between 0.02 bar and 0.3 bar at a temperature of 20°C.

10. The method of any of the preceding claims, wherein the dielectric breakdown strength $E_{bd}$ of the insulation fluid (10) is derivable using a plurality of the component concentrations $c_X$, $c_Y$, and $c_Z$ of the components X, Y, and Z according to

$$E_{bd} = S(c_X, c_Y, c_Z, \ldots) \sum_{i=X,Y,Z,\ldots} c_i E_{crit,i}$$

with $c_X$, $c_Y$, and $c_Z$ being the component concentrations of the components X, Y, and Z; with $E_{crit,X}$, $E_{crit,Y}$, and $E_{crit,Z}$ being component-specific critical field strengths of the components X, Y, and Z; with $S(c_X, c_Y, c_Z)$ being a component-specific synergy parameter; and with i being an index for the components X, Y, and Z,
wherein the components X, Y, and Z and/or the component concentrations $c_X$, $c_Y$, and $c_Z$ are selected such that the synergy parameter $S(c_X, c_Y, c_Z)$ is greater than 1 for at least one combination of the component concentrations $c_X$, $c_Y$, and $c_Z$.

11. The method of any of the preceding claims wherein the first component group A comprises the components X and Y and the second component group B comprises at least the component Z, and
wherein a component-group-specific critical field strength $E_{crit,A}$ for the first component group A and/or a component-group-specific critical field strength $E_{crit,B}$ for the second component group B is or are derivable according to

$$E_{crit,A} = S_A(c_X, c_Y) \sum_{i=X,Y} c_i E_{crit,i}$$

and/or

$$E_{crit,B} = S_B(c_Z, \ldots) \sum_{i=Z,\ldots} c_i E_{crit,i}$$

with $c_X$, $c_Y$, and $c_Z$ being the component concentrations of the components X, Y, and Z; with $E_{crit,X}$, $E_{crit,Y}$, and $E_{crit,Z}$ being component-specific critical field strengths of the components X, Y, and Z; with $S_A(c_X, c_Y)$ and $S_B(c_Z,\ldots)$ being

intra-component group synergy parameters of the component groups A and B; and with i being an index for the components X and Y for component group A and for at least the component Z for component group B.

**12.** The method of claim 11, wherein the components X, Y, and Z and/or the component concentrations $c_X$, $c_Y$, and $c_Z$ are selected such that the intra-component group synergy parameter or intra-component group synergy parameters $S_A(c_X, c_Y)$ and/or $S_B(c_Z,...)$ is or are equal to 1.

**13.** The method of any of the preceding claims, further comprising the method element of deriving the dielectric breakdown strength $E_{bd}$ of the insulation fluid (10) according to

$$E_{bd} = S(c_A, c_B) \sum_{i=A,B} c_i E_{crit,i}$$

with $E_{crit,A}$ and $E_{crit,B}$ being component-group-specific critical field strengths of the component groups A and B; with $c_A$ and $c_B$ being the group concentrations of the first and second component groups A and B; with $S(c_A, c_B)$ being an inter-component group synergy parameter; and with i being an index for the component groups A and B.

**14.** The method of claim 13, wherein the components X, Y, and Z and/or the component concentrations $c_X$, $c_Y$, and $c_Z$ are selected such that the inter-component group synergy parameter $S(c_A, c_B)$ is greater than 1 for at least one combination of the group concentrations $c_A$ and $c_B$ of the first and second component groups A and B.

**15.** The method of any of the preceding claims, further comprising the method element of deriving the component concentrations $c_X$, $c_Y$, and $c_Z$ of the components X, Y, and Z using the measurement variables ($\rho$, p, T, $\lambda$, $\eta$, $c_S$) by using at least one relating equation,
wherein the relating equation is the same or different for each of the components X, Y, and Z.

**16.** The method of claim 1 or 15, wherein the relating equation or relating equations is or are selected from the group consisting of: ideal gas law, van-der-Waals equation of state, virial equation of state, Beattie-Bridgeman equation of state, and Peng-Robinson equation of state.

**17.** The method of any of the preceding claims, wherein at least three measurement variables ($\rho$, p, T, $\lambda$, $\eta$, $c_S$) are measured by means of the at least one sensor (30) and wherein a or the relating equation or relating equations is or are used to derive the group concentrations $c_A$ and $c_B$ of the component groups A and B by using the measurement variables ($\rho$, p, T, $\lambda$, $\eta$, $c_S$), and
wherein the relating equation or relating equations is or are functions of at least one weighted average value of a component-specific parameter, in particular of a molecular mass (M), for the first and second component groups A and B.

**18.** The method of the preceding claims, wherein the measurement variables ($\rho$, p, T, $\lambda$, $\eta$, $c_S$) are indicative of at least the pressure (p), the temperature (T) and a density (p) of the insulation fluid (10).

**19.** The method of any of the preceding claims, wherein the measurement variables ($\rho$, p, T, $\lambda$, $\eta$, $c_S$) are additionally indicative of at least one element of the group consisting of: a thermal conductivity ($\lambda$), a viscosity ($\eta$), and a speed of sound ($c_S$) of or in the insulation fluid (10).

**20.** The method of any of the preceding claims, wherein a ratio of the component concentrations of the components in each component group A and B is constant or varies less than $\pm$10%, preferably less than $\pm$1%, over a period of application of the method.

**21.** The method of any of the preceding claims, wherein the operating parameter P of the fluid-insulated electrical apparatus (1) is selected from the group consisting of:

- the dielectric breakdown strength $E_{bd}$ itself,
- a state of an indicator element, the state being dependent on the dielectric breakdown strength $E_{bd}$,
- a change over time of the dielectric break-down strength $E_{bd}$, and
- a Boolean variable with a variable value being dependent on the dielectric breakdown strength $E_{bd}$.

**22.** The method of any of the preceding claims, wherein the insulation fluid (10) comprises at least four components X, Y, Z, and ZZ with component concentrations $c_X$, $c_Y$, $c_Z$, and $c_{ZZ}$,
the method comprising the method elements of:

- assigning the at least four components to at least three component groups A, B, and C with group concentrations $c_A$, $c_B$, and $c_C$, wherein at least one of the component groups comprises at least two of the components,
- determining at least one quantity of the insulation fluid (10) which is indicative of the group concentrations,
- deriving the dielectric breakdown strength $E_{bd}$ of the insulation fluid (10) according to

$$E_{bd} = S(c_A, c_B, c_C, \ldots) \sum_{i=A,B,C,\ldots} c_i E_{crit,i}$$

with $E_{crit,i}$ for i=A, B, C,... being component group specific critical field strengths of the component groups; with $c_i$ for i=A, B, C,... being the group concentrations of the component groups; with S($c_A$, $c_B$, $c_C$, ...) being an inter-component group synergy parameter; and with i being an index for the component groups A, B, C,

**23.** A method for deriving a dielectric break-down strength $E_{bd}$ of an insulation fluid (10) for a fluid-insulated electrical apparatus (1), in particular for gas-insulated medium or high voltage switchgear (1), which insulation fluid (10) comprises at least three components X, Y, and Z with component concentrations $c_X$, $c_Y$, and $c_Z$,
the method comprising the method elements of

- measuring by means of at least one sensor (30) a plurality of measurement variables ($\rho$, p, T, $\lambda$, $\eta$, $c_S$)
- assigning the at least three components X, Y, and Z to at least a first component group A with a group concentration $c_A$ and to at least a second component group B with a group concentration $c_B$, wherein at least the first component group A comprises at least two of the components X, Y, and Z or wherein at least the second component group B comprises at least two of the components X, Y, and Z,
- determining, by using the measurement variables ($\rho$, p, T, $\lambda$, $\eta$, $c_S$), the group concentration $c_A$ of the first component group A and the group concentration $c_B$ of the second component group B, and
- deriving the dielectric break-down strength $E_{bd}$ by using the group concentration $c_A$ and the group concentration $c_B$.

**24.** A method according to any of the preceding claims, wherein whenever the dielectric breakdown strength $E_{bd}$ of the insulation fluid (10) decreases below a threshold, in particular when the electrical apparatus (1) leaves an "operational" operating state as defined by the operating parameter P, an alert signal is issued, in particular from a control unit 40 to a user, and/or the electrical apparatus (1) is shut down.

**25.** A method for operating a fluid-insulated electrical apparatus (1), in particular gas-isolated medium or high voltage switchgear, using a method of any of the claims 1 to 24.

**26.** The method of claim 25, further comprising a method element of circulating the insulation fluid (10) for homogenizing a density and/or a mixture of the first and/or the second and/or the third components X, Y, and/or Z, in particular before carrying out the method element of deriving the group concentrations $c_A$ and $c_B$ of the component groups A and B.

**27.** The method of any of the claims 25 to 26, further comprising at least one method element of the group consisting of:

- increasing at least one of the component concentrations $c_X$, $c_Y$, and/or $c_Z$ of the components X, Y, and/or Z of the insulation fluid (10), in particular by means of injecting an amount of at least one of the components X, Y, and/or Z from a component reservoir (70) into a compartment (50) of the electrical apparatus (1),
- reducing at least one of the component concentrations $c_X$, $c_Y$, and/or $c_Z$ of the components X, Y, and/or Z of the insulation fluid (10),
- reducing a concentration of at least one contaminant in the insulation fluid (10), in particular by means of a filter (90),
- at least partially evaporating a condensed amount of at least one of the components X, Y, and/or Z of the insulation fluid (10), in particular by means of a heater (80), and
- condensing an amount of at least one of the components X, Y, and/or Z of the insulation fluid (10), in particular by means of a cooler.

**28.** A fluid-insulated electrical apparatus (1), which is a gas-isolated medium or high voltage switchgear or a transformer, comprising:

an insulation fluid (10) which comprises at least three components X, Y, and Z,
at least one sensor (30) for measuring a plurality of measurement variables (p, p, T, $\lambda$, $\eta$, $c_S$), and
a control and analysis unit (40) adapted to carry out the steps or method elements of the method of claim 1, including:

- deriving at least one operating parameter P of the fluid-insulated electrical apparatus (1), which derived operating parameter P is dependent on a dielectric breakdown strength $E_{bd}$ of the insulation fluid (10) of the electrical apparatus (1) and defines an operational operating state or a failure state of the electrical apparatus (1),
- measuring by means of the at least one sensor (30) the plurality of the measurement variables ($\rho$, p, T, $\lambda$, $\eta$, $c_S$), wherein the measurement variables ($\rho$, p, T, $\lambda$, $\eta$, $c_S$) are indicative of at least a pressure (p) and a temperature (T) of the insulation fluid (10),
- assigning the at least three components X, Y, and Z to at least a first component group A with a group concentration $c_A$ and to at least a second component group B with a group concentration $c_B$, wherein at least the first component group A comprises at least two of the components X, Y, and Z or wherein at least the second component group B comprises at least two of the components X, Y, and Z,
- wherein the at least three components X, Y, and Z are assigned to the at least two component groups A and B in such a way that a weighted average value $M_A$ of a molecular mass of the component or components in the first component group A differs from a weighted average value $M_B$ of a molecular mass of the component or components in the second component group B,
- deriving the group concentrations $c_A$ and $c_B$ of the component groups A and B by using the measurement variables ($\rho$, p, T, $\lambda$, $\eta$, $c_S$) and at least one relating equation, which is the same or different for each of the component groups A and B, and
- deriving the operating parameter P using the group concentration $c_A$ and the group concentration $c_B$.

**29.** A fluid-insulated electrical apparatus (1), which is a gas-isolated medium or high voltage switchgear or a transformer, comprising:

an insulation fluid (10) which comprises at least three components X, Y, and Z,
at least one sensor (30) for measuring a plurality of measurement variables ($\rho$, p, T, $\lambda$, $\eta$, $c_S$), and
a control and analysis unit (40) adapted to carry out the steps or method elements of the method of claim 23, including:

- deriving a dielectric break-down strength $E_{bd}$ of the insulation fluid (10),
- measuring by means of the at least one sensor (30) the plurality of measurement variables ($\rho$, p, T, $\lambda$, $\eta$, $c_S$)
- assigning the at least three components X, Y, and Z to at least a first component group A with a group concentration $c_A$ and to at least a second component group B with a group concentration $c_B$, wherein at least the first component group A comprises at least two of the components X, Y, and Z or wherein at least the second component group B comprises at least two of the components X, Y, and Z,
- determining, by using the measurement variables ($\rho$, p, T, A, $\eta$, $c_S$), the group concentration $c_A$ of the first component group A and the group concentration $c_B$ of the second component group B, and
- deriving the dielectric break-down strength $E_{bd}$ by using the group concentration $c_A$ and the group concentration $c_B$.

**30.** A computer program element comprising computer program code means for, when executed by a processing unit, implementing a method according to any one of the claims 1 to 27.

**Patentansprüche**

**1.** Verfahren zur Ableitung mindestens eines Betriebsparameters P einer fluidisolierten elektrischen Vorrichtung (1), bei der es sich um eine gasisolierte Mittel- oder Hochspannungsschaltanlage (1) oder einen Transformator handelt und die ein Isolierfluid (10) mit mindestens drei Komponenten X, Y und Z mit Komponentenkonzentrationen $c_X$, $c_Y$ und $c_Z$ umfasst, und
wobei der abgeleitete Betriebsparameter P von einer dielektrischen Durchschlagsfestigkeit $E_{bd}$ des Isolierfluids (10)

der elektrischen Vorrichtung (1) abhängt und einen funktionsfähigen Betriebszustand oder einen Fehlerzustand der elektrischen Vorrichtung (1) definiert,
wobei das Verfahren die folgenden Verfahrenselemente umfasst:

- Messen durch mindestens einen Sensor (30) einer Mehrzahl von Messvariablen ($\rho$, p, T, $\lambda$, $\eta$, $c_S$), wobei die Messvariablen ($\rho$, p, T, $\lambda$, $\eta$, $c_S$) mindestens einen Druck (p) und eine Temperatur (T) des Isolierfluids (10) anzeigen,
- Zuordnen der mindestens drei Komponenten X, Y und Z zu mindestens einer ersten Komponentengruppe A mit einer Gruppenkonzentration $c_A$ und zu mindestens einer zweiten Komponentengruppe B mit einer Gruppenkonzentration $c_B$, wobei mindestens die erste Komponentengruppe A mindestens zwei der Komponenten X, Y und Z umfasst, oder wobei mindestens die zweite Komponentengruppe B mindestens zwei der Komponenten X, Y und Z umfasst,
- wobei die mindestens drei Komponenten X, Y und Z derart zu den mindestens zwei Komponentengruppen A und B zugeordnet werden, dass sich ein gewichteter Mittelwert $M_A$ einer Molekularmasse der Komponente oder der Komponenten in der ersten Komponentengruppe A von einem gewichteten Mittelwert $M_B$ einer Molekularmasse der Komponente oder der Komponenten in der zweiten Komponentengruppe B unterscheidet,
- Ableiten der Gruppenkonzentrationen $c_A$ und $c_B$ der Komponentengruppen A und B durch Verwenden der Messvariablen ($\rho$, p, T, $\lambda$, $\eta$, $c_S$) und mindestens einer in Beziehung stehenden Gleichung, die für jede der Komponentengruppen A und B gleich oder verschieden ist, und
- Ableiten des Betriebsparameters P unter Verwendung der Gruppenkonzentration $c_A$ und der Gruppenkonzentration $c_B$.

**2.** Verfahren nach Anspruch 1, wobei ein absoluter Wert $|MA - M_B|$ der Differenz zwischen den gewichteten Mittelwerten $M_A - M_B$ der Molekularmassen der Komponenten X, Y und Z zwischen den ersten und zweiten Komponentengruppen A und B größer als gewichtete statistische Streuungen $\sigma_{M,A}$ und $\sigma_{M,B}$ der Molekularmassen der Komponenten X, Y und Z innerhalb der ersten und zweiten Komponentengruppen A und B ist.

**3.** Verfahren nach Anspruch 2, wobei der absolute Wert $|MA - M_B|$ der Differenz zwischen den gewichteten Mittelwerten $M_A - M_B$ der Molekularmassen der Komponenten X, Y und Z zwischen den ersten und zweiten Komponentengruppen A und B größer als 20 g/mol, vorzugsweise größer als 50 g/mol, insbesondere größer als 100 g/mol ist.

**4.** Verfahren nach einem der vorhergehenden Ansprüche, wobei die mindestens drei Komponenten X, Y und Z derart zu den mindestens zwei Komponentengruppen A und B zugeordnet werden, dass sich ein gewichteter Mittelwert $E_{crit,A}$ einer kritischen Feldstärke der Komponente oder der Komponenten in der ersten Komponentengruppe A von einem gewichteten Mittelwert $E_{crit,B}$ einer kritischen Feldstärke der Komponente oder der Komponenten in der zweiten Komponentengruppe B unterscheidet.

**5.** Verfahren nach Anspruch 4, wobei ein absoluter Wert $|E_{crit,A} - E_{crit,B}|$ der Differenz zwischen den gewichteten Mittelwerten $E_{crit,A} - E_{crit,B}$ der kritischen Feldstärken der Komponenten X, Y und Z zwischen den ersten und zweiten Komponentengruppen A und B größer als gewichtete statistische Streuungen $\sigma_{Ecrit,A}$ und $\sigma_{Ecrit,B}$ der kritischen Feldstärken der Komponenten X, Y und Z innerhalb der ersten und zweiten Komponentengruppen A und B ist.

**6.** Verfahren nach einem der vorhergehenden Ansprüche, wobei die zweite Komponentengruppe B mindestens eine der Komponenten aus der Gruppe umfasst, die besteht aus:

- Schwefelhexafluorid,
- teilweise oder vollständig fluorierten Ethern, insbesondere Hydrofluorethern, Hydrofluormonoethern, Hydrofluormonoethern mit mindestens 3 Kohlenstoffatomen, Perfluormonoethern, oder Perfluormonoethern mit mindestens 4 Kohlenstoffatomen,
- teilweise oder vollständig fluorierten Ketonen, insbesondere Hydrofluormonoketonen, Perfluormonoketonen, Perfluormonoketonen mit mindestens 5 Kohlenstoffatomen oder Perfluormonoketonen mit genau 5 oder 6 oder 7 oder 8 Kohlenstoffatomen, und
- Gemischen davon, und

wobei die erste Komponentengruppe A mindestens eine der Komponenten aus der Gruppe umfasst, die besteht aus:

- Stickstoff,
- Sauerstoff,

- Kohlendioxid,
- Stickoxid,
- Stickstoffdioxid,
- Distickstoffoxid,
- Argon,
- Methanen, insbesondere teilweise oder vollständig halogenierten Methanen, insbesondere Tetrafluormethan oder Trifluoriodmethan,
- Luft, insbesondere technischer Luft oder synthetischer Luft, und
- Gemischen davon.

**7.** Verfahren nach Anspruch 6, wobei die zweite Komponentengruppe B mindestens eine Komponente aus der Gruppe umfasst, die besteht aus:

- cyclischen und/oder aliphatischen Fluorpentanonen, vorzugsweise cyclischen und/oder aliphatischen Perfluorpentanonen, insbesondere 1,1,1,3,4,4,4-Heptafluor-3-(trifluormethyl)butan-2-on,
- cyclischen und/oder aliphatischen Fluorhexanonen, vorzugsweise cyclischen und/oder aliphatischen Perfluorhexanonen, insbesondere 1,1,1,2,4,4,5,5,5-Nonafluor-4-(trifluormethyl)pentan-3-on,
- cyclischen und/oder aliphatischen Fluorheptanonen, vorzugsweise cyclischen und/oder aliphatischen Perfluorheptanonen,
- Schwefelhexafluorid, und
- Hydrofluorethern.

**8.** Verfahren nach einem der Ansprüche 6 bis 7, wobei die erste Komponentengruppe A umfasst:

die Komponenten Stickstoff und Sauerstoff mit relativen Partialdrücken zwischen $p(N_2)/(p(O_2) + p(N_2)) = 0,7$, $p(O_2)/(p(O_2) + p(N_2)) = 0,3$ und $p(N_2)/(p(0_2) + p(N_2)) = 0,95$, $P(O_2)/(P(O_2) + p(N_2)) = 0,05$, oder
die Komponenten Kohlendioxid und Sauerstoff mit relativen Partialdrücken zwischen $p (CO_2) / (p (O_2) + p(CO_2)) = 0,6$, $p(O_2)/(p(O_2) + p (CO_2) ) = 0,4$ und $p(CO_2)/(p(O_2) + p(CO2)) = 0,99$, $p(O_2)/(p(O_2) + p(CO_2)) = 0,01$, oder
die Komponenten Kohlendioxid und Stickstoff mit relativen Partialdrücken zwischen $p(CO_2)/(p(N2) + p(CO_2)) = 0,1$, $p(N_2)/(p(N_2) + p(CO_2)) = 0,9$ und $p(CO_2)/(p(N_2) + p(CO_2)) = 0,9$,$p(N_2)/(p(N_2) + p(CO_2)) = 0,1$, und

wobei die zweite Komponentengruppe B mindestens eine der Komponenten aus der Gruppe umfasst, die besteht aus:

1,1,1,3,4,4,4-Heptafluor-3-(trifluormethyl)butan-2-on mit einem Partialdruck zwischen 0,1 bar und 0,7 bar bei einer Temperatur von 20 °C,
1,1,1,2,4,4,5,5,5-Nonafluor-4-(trifluormethyl)pentan-3-on mit einem Partialdruck zwischen 0,01 bar und 0,3 bar bei einer Temperatur von 20 °C,
Schwefelhexafluorid mit einem Partialdruck zwischen 0,1 bar und 2 bar bei einer Temperatur von 20 °C, und einem oder mehreren Hydrofluorethern mit einem Partialdruck zwischen 0,2 bar und 1 bar bei einer Temperatur von 20 °C.

**9.** Verfahren nach einem der Ansprüche 6 bis 8, wobei die erste Komponentengruppe A umfasst:

die Komponenten Stickstoff und Sauerstoff mit relativen Partialdrücken zwischen $p(N_2)/(p(O_2) + p(N_2)) = 0,75$,$p(O_2)/(p(O_2) + p(N_2)) = 0,25$ und $p(N_2)/(p(O_2) + p(N_2)) = 0,90$,$P(O_2)/(P(O_2) + p(N_2)) = 0,10$, und
wobei die zweite Komponentengruppe B die Komponente 1,1,1,3,4,4,4-Heptafluor-3-(trifluormethyl)butan-2-on mit einem Partialdruck zwischen 0,25 bar und 0,5 bar und/oder die Komponente 1,1,1,2,4,4,5,5,5-Nonafluor-4-(trifluormethyl)pentan-3-on mit einem Partialdruck zwischen 0,02 bar und 0,3 bar bei einer Temperatur von 20 °C umfasst.

**10.** Verfahren nach einem der vorhergehenden Ansprüche, wobei die dielektrische Durchschlagsfestigkeit $E_{bd}$ des Isolierfluids (10) unter Verwendung einer Mehrzahl der Komponentenkonzentrationen $C_X$, $C_Y$ und $C_Z$ der Komponenten X, Y und Z abgeleitet werden kann gemäß

$$E_{bd} = S(c_X, c_Y, c_Z, \ldots) \sum_{i=X,Y,Z,\ldots} c_i E_{crit,i}$$

wobei $C_X$, $C_Y$ und $C_Z$ die Komponentenkonzentrationen der Komponenten X, Y und Z sind; $E_{crit,X}$, $E_{crit,Y}$ und $E_{crit,Z}$ komponentenspezifische kritische Feldstärken der Komponenten X, Y und Z sind; S ($C_X$, $C_Y$, $C_Z$) ein komponentenspezifischer Synergieparameter ist; und i ein Index für die Komponenten X, Y und Z ist,
wobei die Komponenten X, Y und Z und/oder die Komponentenkonzentrationen $C_X$, $C_Y$ und $C_Z$ derart ausgewählt werden, dass der Synergieparameter S($C_X$, $C_Y$, $C_Z$) für mindestens eine Kombination der Komponentenkonzentrationen $C_X$, $C_Y$ und $C_Z$ größer als 1 ist.

**11.** Verfahren nach einem der vorhergehenden Ansprüche, wobei die erste Komponentengruppe A die Komponenten X und Y umfasst, und die zweite Komponentengruppe B mindestens die Komponente Z umfasst, und
wobei eine komponentengruppenspezifische kritische Feldstärke $E_{crit,A}$ für die erste Komponentengruppe A und/oder eine komponentengruppenspezifische kritische Feldstärke $E_{crit,B}$ für die zweite Komponentengruppe B abgeleitet werden kann bzw. können gemäß

$$E_{crit,A} = S_A(c_X, c_Y) \sum_{i=X,Y} c_i E_{crit,i}$$

und/oder

$$E_{crit,B} = S_B(c_Z, \ldots) \sum_{i=Z,\ldots} c_i E_{crit,i}$$

wobei $C_X$, $C_Y$ und $C_Z$ die Komponentenkonzentrationen der Komponenten X, Y und Z sind; $E_{crit,X}$, $E_{crit,Y}$ und $E_{crit,Z}$ komponentenspezifische kritische Feldstärken der Komponenten X, Y und Z sind; $S_A$($C_X$, $C_Y$) und $S_B$ ($C_Z$, ...) komponentengruppeninterne Synergieparameter der Komponentengruppen A und B sind; und i ein Index für die Komponenten X und Y für die Komponentengruppe A und für mindestens die Komponente Z für die Komponentengruppe B ist.

**12.** Verfahren nach Anspruch 11, wobei die Komponenten X, Y und Z und/oder die Komponentenkonzentrationen $C_X$, $C_Y$ und $C_Z$ derart ausgewählt werden, dass der komponentengruppeninterne Synergieparameter oder die komponentengruppeninternen Synergieparameter $S_A$($C_X$, $C_Y$) und/oder $S_B$ ($C_Z$, ...) gleich 1 ist bzw. sind.

**13.** Verfahren nach einem der vorhergehenden Ansprüche, ferner umfassend das Verfahrenselement des Ableitens der dielektrischen Durchschlagsfestigkeit des Isolierfluids (10) gemäß

$$E_{bd} = S(c_A, c_B) \sum_{i=A,B} c_i E_{crit,i}$$

wobei $E_{crit,A}$ und $E_{crit,B}$ komponentengruppenspezifische kritische Feldstärken der Komponentengruppen A und B sind; $C_A$ und $C_B$ die Gruppenkonzentrationen der ersten und zweiten Komponentengruppen A und B sind; S($C_A$, $C_B$) ein komponentengruppeninterner Synergieparameter ist; und i ein Index für die Komponentengruppen A und B ist.

**14.** Verfahren nach Anspruch 13, wobei die Komponenten X, Y und Z und/oder die Komponentenkonzentrationen $C_X$, $C_Y$ und $C_Z$ derart ausgewählt werden, dass der komponentengruppeninterne Synergieparameter S($C_A$, $C_B$) für mindestens eine Kombination der Gruppenkonzentrationen $C_A$ und $C_B$ der ersten und zweiten Komponentengruppen A und B größer als 1 ist.

**15.** Verfahren nach einem der vorhergehenden Ansprüche, ferner umfassend das Verfahrenselement des Ableitens der Komponentenkonzentrationen $C_X$, $C_Y$ und $C_Z$ der Komponenten X, Y und Z unter Verwendung der Messvariablen ($\rho$, p, T, $\lambda$, $\eta$, $C_S$) durch Verwenden mindestens einer in Beziehung stehenden Gleichung,
wobei die in Beziehung stehende Gleichung für jede der Komponenten X, Y und Z gleich oder verschieden ist.

**16.** Verfahren nach Anspruch 1 oder 15, wobei die in Beziehung stehende Gleichung oder die in Beziehung stehenden Gleichungen aus der Gruppe ausgewählt wird bzw. werden, die besteht aus: der Zustandsgleichung für ideale Gase, der Zustandsgleichung nach van der Waals, der Virial-Zustaudsgleichung, der Zustandsgleichung nach Beattie und

Bridgeman und der Zustandsgleichung nach Peng und Robinson.

**17.** Verfahren nach einem der vorhergehenden Ansprüche, wobei mindestens drei Messvariablen ($\rho$, p, T, $\lambda$, $\eta$, $C_S$) durch den mindestens einen Sensor (30) gemessen werden, und wobei eine oder die in Beziehung stehende Gleichung oder die in Beziehung stehenden Gleichungen zum Ableiten der Gruppenkonzentrationen $C_A$ und $C_B$ der Komponentengruppen A und B durch Verwenden der Messvariablen ($\rho$, p, T, $\lambda$, $\eta$, $C_S$) verwendet wird bzw. werden, und
wobei die in Beziehung stehende Gleichung oder die in Beziehung stehenden Gleichungen Funktionen mindestens eines gewichteten Mittelwerts eines komponentenspezifischen Parameters, insbesondere einer Molekularmasse (M), für die ersten und zweiten Komponentengruppen A und B ist bzw. sind.

**18.** Verfahren nach einem der vorhergehenden Ansprüche, wobei die Messvariablen ($\rho$, p, T, $\lambda$, $\eta$, $C_S$) mindestens den Druck (p), die Temperatur (T) und eine Dichte (p) des Isolierfluids (10) anzeigen.

**19.** Verfahren nach einem der vorhergehenden Ansprüche, wobei die Messvariablen ($\rho$, p, T, $\lambda$, $\eta$, $C_S$) außerdem mindestens ein Element aus der Gruppe anzeigen, die besteht aus: einer thermischen Leitfähigkeit ($\lambda$), einer Viskosität ($\eta$) und einer Schallgeschwindigkeit ($C_S$) von oder in dem Isolierfluid (10).

**20.** Verfahren nach einem der vorhergehenden Ansprüche, wobei ein Verhältnis der Komponentenkonzentrationen der Komponenten in jeder Komponentengruppe A und B über einen Anwendungszeitraum des Verfahrens konstant ist oder um weniger als $\pm$10 %, vorzugsweise um weniger als $\pm$1 % variiert.

**21.** Verfahren nach einem der vorhergehenden Ansprüche, wobei der Betriebsparameter P der fluidisolierten elektrischen Vorrichtung (1) aus der Gruppe ausgewählt ist, die besteht aus:

- der dielektrischen Durchschlagsfestigkeit $E_{bd}$ selbst,
- einem Zustand eines Indikatorelements, wobei der Zustand von der dielektrischen Durchschlagsfestigkeit $E_{bd}$ abhängt,
- einer Änderung im Zeitablauf der dielektrischen Durchschlagsfestigkeit $E_{bd}$, und
- einer booleschen Variablen mit einem Variablenwert, der von der dielektrischen Durchschlagsfestigkeit $E_{bd}$ abhängt.

**22.** Verfahren nach einem der vorhergehenden Ansprüche, wobei das Isolierfluid (10) mindestens vier Komponenten X, Y, Z und ZZ mit Komponentenkonzentrationen $C_X$, $C_Y$, $C_Z$ und $C_{ZZ}$ umfasst,
wobei das Verfahren die folgenden Verfahrenselemente umfasst:

- Zuordnen der mindestens vier Komponenten zu mindestens drei Komponentengruppen A, B und C mit Gruppenkonzentrationen $C_A$, $C_B$ und $C_C$, wobei mindestens eine der Komponentengruppen mindestens zwei der Komponenten umfasst,
- Bestimmen mindestens einer Quantität des Isolierfluids (10), welche die Gruppekonzentrationen anzeigt,
- Ableiten der dielektrischen Durchschlagsfestigkeit $E_{bd}$ des Isolierfluids (10) gemäß

$$E_{bd} = S(c_A, c_B, c_C, \ldots) \sum_{i=A,B,C,\ldots} c_i E_{crit,i}$$

wobei $E_{crit,i}$ für i = A, B, C, ... komponentengruppenspezifische kritische Feldstärken der Komponentengruppen sind; $C_i$ für i = A, B, C, ... die Gruppenkonzentrationen der Komponentengruppen sind; S ($C_A$, $C_B$, $C_C$, ...) ein Synergieparameter zwischen Komponentengruppen ist; und i ein Index für die Komponentengruppen A, B, C, ... ist.

**23.** Verfahren zur Ableitung einer dielektrischen Durchschlagsfestigkeit $E_{bd}$ eines Isolierfluids (10) für eine fluidisolierte elektrischen Vorrichtung (1), insbesondere für eine gasisolierte Mittel- oder Hochspannungsschaltanlage (1), die ein Isolierfluid (10) mit mindestens drei Komponenten X, Y und Z mit Komponentenkonzentrationen $C_X$, $C_Y$ und $C_Z$ umfasst, und wobei das Verfahren die folgenden Verfahrenselemente umfasst:

- Messen durch mindestens einen Sensor (30) einer Mehrzahl von Messvariablen ($\rho$, p, T, $\lambda$, $\eta$, $C_S$),
- Zuordnen der mindestens drei Komponenten X, Y und Z zu mindestens einer ersten Komponentengruppe A mit einer Gruppenkonzentration $C_A$ und zu mindestens einer zweiten Komponentengruppe B mit einer Gruppenkonzentration $C_B$, wobei mindestens die erste Komponentengruppe A mindestens zwei der Komponenten X, Y und Z umfasst, oder wobei mindestens die zweite Komponentengruppe B mindestens zwei der Komponenten X, Y und Z umfasst,
- Bestimmen durch Verwenden der Messvariablen (p, p, T, $\lambda$, $\eta$, $C_S$) der Gruppenkonzentration $C_A$ der ersten Komponentengruppe A und der Gruppenkonzentration $C_B$ der zweiten Komponentengruppe B, und
- Ableiten der dielektrischen Durchschlagsfestigkeit $E_{bd}$ durch Verwenden der Gruppenkonzentration $C_A$ und der Gruppenkonzentration $C_B$.

**24.** Verfahren nach einem der vorhergehenden Ansprüche, wobei, wann immer die dielektrische Durchschlagsfestigkeit $E_{bd}$ des Isolierfluids (10) unter eine Schwelle abfällt, insbesondere wenn die elektrische Vorrichtung (1) einen "funktionsfähigen" Betriebszustand, wie durch den Betriebsparameter P definiert, verlässt, ein Warnsignal, insbesondere von einer Steuereinheit 40 an einen Benutzer, ausgegeben wird und/oder die elektrische Vorrichtung (1) abgeschaltet wird.

**25.** Verfahren zum Betreiben einer fluidisolierten elektrischen Vorrichtung (1), insbesondere einer gasisolierten Mittel- oder Hochspannungsschaltanlage, unter Verwendung eines Verfahrens nach einem der Ansprüche 1 bis 24.

**26.** Verfahren nach Anspruch 25, ferner umfassend ein Verfahrenselement des Zirkulierenlassens des Isolierfluids (10) zum Homogenisieren einer Dichte und/oder eines Gemisches der ersten und/oder der zweiten und/oder der dritten Komponenten X, Y und/oder Z insbesondere vor dem Ausführen des Verfahrenselements des Ableitens der Gruppenkonzentrationen $C_A$ und $C_B$ der Komponentengruppen A und B.

**27.** Verfahren nach einem der Ansprüche 25 bis 26, ferner umfassend mindestens ein Verfahrenselement der Gruppe bestehend aus:

- Erhöhen mindestens einer der Komponentenkonzentrationen $C_X$, $C_Y$ und/oder $C_Z$ der Komponenten X, Y und/oder Z des Isolierfluids (10), insbesondere durch Injizieren einer Menge mindestens einer der Komponenten X, Y und/oder Z aus einem Komponentenreservoir (70) in eine Kammer (50) der elektrischen Vorrichtung (1),
- Verringern mindestens einer der Komponentenkonzentrationen $C_X$, $C_Y$ und/oder $C_Z$ der Komponenten X, Y und/oder Z des Isolierfluids (10),
- Verringern einer Konzentration mindestens eines Kontaminanten im Isolierfluid (10), insbesondere durch ein Filter (90),
- wenigstens teilweises Verdampfen einer kondensierten Menge mindestens einer der Komponenten X, Y, und/oder Z des Isolierfluids (10), insbesondere durch ein Heizelement (80), und
- Kondensieren einer Menge mindestens einer der Komponenten X, Y und/oder Z des Isolierfluids (10), insbesondere durch einen Kühler.

**28.** Fluidisolierte elektrische Vorrichtung (1), bei der es sich um eine gasisolierte Mittel- oder Hochspannungsschaltanlage oder einen Transformator handelt, umfassend:

ein Isolierfluid (10), das mindestens drei Komponenten X, Y und Z umfasst,
mindestens einen Sensor (30) zum Messen einer Mehrzahl von Messvariablen ($\rho$, p, T, $\lambda$, $\eta$, $C_S$), und
eine Steuer- und Analyseeinheit (40), die zum Ausführen der Schritte oder Verfahrenselemente des Verfahrens nach Anspruch 1 ausgelegt ist, umfassend:

- Ableiten mindestens eines Betriebsparameters P der fluidisolierten elektrischen Vorrichtung (1), wobei der abgeleitete Betriebsparameter P von einer dielektrischen Durchschlagsfestigkeit $E_{bd}$ des Isolierfluids (10) der elektrischen Vorrichtung (1) abhängt und einen funktionsfähigen Betriebszustand oder einen Fehlerzustand der elektrischen Vorrichtung (1) definiert,
- Messen durch den mindestens einen Sensor (30) der Mehrzahl von Messvariablen ($\rho$, p, T, $\lambda$, $\eta$, $C_S$), wobei die Messvariablen ($\rho$, p, T, $\lambda$, $\eta$, $C_S$) mindestens einen Druck (p) und eine Temperatur (T) des Isolierfluids (10) anzeigen,
- Zuordnen der mindestens drei Komponenten X, Y und Z zu mindestens einer ersten Komponentengruppe A mit einer Gruppenkonzentration $C_A$ und zu mindestens einer zweiten Komponentengruppe B mit einer Gruppenkonzentration $C_B$, wobei mindestens die erste Komponentengruppe A mindestens zwei der Komponenten X, Y und Z umfasst, oder wobei mindestens die zweite Komponentengruppe B mindestens zwei der Komponenten X, Y und Z umfasst,
- wobei die mindestens drei Komponenten X, Y und Z derart zu den mindestens zwei Komponentengruppen

A und B zugeordnet werden, dass sich ein gewichteter Mittelwert $M_A$ einer Molekularmasse der Komponente oder Komponenten in der ersten Komponentengruppe A von einem gewichteten Mittelwert $M_B$ einer Molekularmasse der Komponente oder Komponenten in der zweiten Komponentengruppe B unterscheidet,
- Ableiten der Gruppenkonzentrationen $C_A$ und $C_B$ der Komponentengruppen A und B durch Verwenden der Messvariablen ($\rho$, p, T, $\lambda$, $\eta$, $C_S$) und mindestens einer in Beziehung stehenden Gleichung, die für jede der Komponentengruppen A und B gleich oder verschieden ist, und
- Ableiten des Betriebsparameters P unter Verwendung der Gruppenkonzentration $C_A$ und der Gruppenkonzentration $C_B$.

**29.** Fluidisolierte elektrische Vorrichtung (1), bei der es sich um eine gasisolierte Mittel- oder Hochspannungsschaltanlage oder einen Transformator handelt, umfassend:

ein Isolierfluid (10), das mindestens drei Komponenten X, Y und Z umfasst,
mindestens einen Sensor (30) zum Messen einer Mehrzahl von Messvariablen ($\rho$, p, T, $\lambda$, $\eta$, $C_S$), und
eine Steuer- und Analyseeinheit (40), die zum Ausführen der Schritte oder Verfahrenselemente des Verfahrens nach Anspruch 23 ausgelegt ist,
umfassend:

- Ableiten einer dielektrischen Durchschlagsfestigkeit $E_{bd}$ des Isolierfluids (10),
- Messen durch den mindestens einen Sensor (30) der Mehrzahl von Messvariablen ($\rho$, p, T, $\lambda$, $\eta$, $C_S$),
- Zuordnen der mindestens drei Komponenten X, Y und Z zu mindestens einer ersten Komponentengruppe A mit einer Gruppenkonzentration $C_A$ und zu mindestens einer zweiten Komponentengruppe B mit einer Gruppenkonzentration $C_B$, wobei mindestens die erste Komponentengruppe A mindestens zwei der Komponenten X, Y und Z umfasst, oder wobei mindestens die zweite Komponentengruppe B mindestens zwei der Komponenten X, Y und Z umfasst,
- Bestimmen durch Verwenden der Messvariablen (p, p, T, $\lambda$, $\eta$, $C_S$) der Gruppenkonzentration $C_A$ der ersten Komponentengruppe A und der Gruppenkonzentration $C_B$ der zweiten Komponentengruppe B, und
- Ableiten der dielektrischen Durchschlagsfestigkeit $E_{bd}$ durch Verwenden der Gruppenkonzentration $C_A$ und der Gruppenkonzentration $C_B$.

**30.** Computerprogrammelement, umfassend Computerprogrammcodemittel zum Implementieren bei Ausführung durch eine Verarbeitungseinheit eines Verfahrens nach einem der Schritte 1 bis 27.

## Revendications

**1.** Procédé de dérivation d'au moins un paramètre de fonctionnement P d'un appareil électrique isolé par un fluide (1), qui est un appareillage de commutation moyenne ou haute tension isolé au gaz (1) ou un transformateur et qui comprend un fluide d'isolation (10) avec au moins trois constituants X, Y et Z avec des concentrations de constituant $C_X$, $C_Y$ et $C_Z$, et
lequel paramètre de fonctionnement dérivé P dépend d'une intensité de claquage diélectrique $E_{bd}$ du fluide d'isolation (10) de l'appareil électrique (1) et définit un état de fonctionnement opérationnel ou un état de défaillance de l'appareil électrique (1),
le procédé comprenant les éléments de procédé consistant à :

- mesurer au moyen d'au moins un capteur (30) une pluralité de variables de mesure ($\rho$, p, T, $\lambda$, $\eta$, $C_S$), les variables de mesure ($\rho$, p, T, $\lambda$, $\eta$, $C_S$) étant représentatives au moins d'une pression (p) et d'une température (T) du fluide d'isolation (10),
- affecter les au moins trois constituants X, Y et Z à au moins un premier groupe de constituants A avec une concentration de groupe $C_A$ et à au moins un deuxième groupe de constituants B avec une concentration de groupe $C_B$, au moins le premier groupe de constituants A comprenant au moins deux des constituants X, Y et Z ou au moins le deuxième groupe de constituants B comprenant au moins deux des constituants X, Y et Z,
- dans lequel les au moins trois constituants X, Y et Z sont affectés aux au moins deux groupes de constituants A et B de telle sorte qu'une valeur moyenne pondérée $M_A$ d'une masse moléculaire du constituant ou des constituants dans le premier groupe de constituants A diffère d'une valeur moyenne pondérée $M_B$ d'une masse moléculaire du constituant ou des constituants dans le deuxième groupe de constituants B,
- dériver les concentrations de groupe $C_A$ et $C_B$ des groupes de constituants A et B à l'aide des variables de mesure ($\rho$, p, T, $\lambda$, $\eta$, $C_S$) et d'au moins une équation associée, qui est identique ou différente pour chacun des

groupes de constituants A et B, et

- dériver le paramètre de fonctionnement P en utilisant la concentration de groupe $C_A$ et la concentration de groupe $C_B$.

**2.** Procédé de la revendication 1, dans lequel une valeur absolue $|M_A-M_B|$ de la différence entre les valeurs moyennes pondérées $M_A-M_B$ des masses moléculaires des constituants X, Y et Z entre le premier et le deuxième groupe de constituants A et B est plus grande que des dispersions statistiques pondérées $\sigma_{M,A}$ et $\sigma_{M,B}$ des masses moléculaires des constituants X, Y et Z dans les premier et deuxième groupes de constituants A et B.

**3.** Procédé de la revendication 2, dans lequel la valeur absolue $|M_A-M_B|$ de la différence entre les valeurs moyennes pondérées $M_A-M_B$ des masses moléculaires des constituants X, Y et Z entre le premier et le deuxième groupe de constituants A et B est plus grande que 20 g/mol, de préférence plus grande que 50 g/mol, mieux encore plus grande que 100 g/mol.

**4.** Procédé de l'une quelconque des revendications précédentes, dans lequel les au moins trois constituants X, Y et Z sont affectés aux au moins deux groupes de constituants A et B de telle sorte qu'une valeur moyenne pondérée $E_{crit,A}$ d'une intensité de champ critique du constituant ou des constituants dans le premier groupe de constituants A diffère d'une valeur moyenne pondérée $E_{crit,B}$ d'une intensité de champ critique du constituant ou des constituants dans le deuxième groupe de constituants B.

**5.** Procédé de la revendication 4, dans lequel une valeur absolue $|E_{crit,A}-E_{crit,B}|$ de la différence entre les valeurs moyennes pondérées $E_{crit,A}$,$E_{crit,B}$ des intensités de champ critique des constituants X, Y et Z entre le premier et le deuxième groupe de constituants A et B est plus grande que des dispersions statistiques pondérées $\sigma_{Ecrit,A}$ et $\sigma_{Ecrit,B}$ des intensités de champ critique des constituants X, Y et Z dans les premier et deuxième groupes de constituants A et B.

**6.** Procédé de l'une quelconque des revendications précédentes, dans lequel le deuxième groupe de constituants B comprend au moins un des constituants de groupe constitué par:

- l'hexafluorure de soufre,
- les éthers partiellement ou totalement fluorés, en particulier les hydrofluoroéthers, les hydrofluoromonoéthers, les hydrofluoromonoéthers contenant au moins 3 atomes de carbone, les perfluoromonoéthers, ou les perfluoromonoéthers contenant au moins 4 atomes de carbone,
- les cétones partiellement ou totalement fluorées, en particulier les hydrofluoromonocétones, les perfluoromonocétones, les perfluoromonocétones comprenant au moins 5 atomes de carbone, ou les perfluoromonocétones comprenant exactement 5 ou 6 ou 7 ou 8 atomes de carbone, et
- les mélanges de ceux-ci, et

dans lequel le premier groupe de constituants A comprend au moins un des constituants du groupe constitué par:

- l'azote,
- l'oxygène,
- le dioxyde de carbone,
- l'oxyde nitrique,
- le dioxyde d'azote,
- l'oxyde nitreux,
- l'argon,
- les méthanes, en particulier les méthanes partiellement ou totalement halogénés, en particulier le tétrafluorométhane ou le trifluoroiodométhane,
- l'air, en particulier l'air technique ou l'air synthétique, et
- les mélanges de ceux-ci.

**7.** Procédé de la revendication 6, dans lequel le deuxième groupe de constituants B comprend au moins un constituant du groupe constitué par:

- les fluoropentanones cycliques et/ou aliphatiques, de préférence les perfluoropentanones cycliques et/ou aliphatiques, mieux encore la 1,1,1,3,4,4,4-heptafluoro-3-(trifluorométhyl)butan-2-one,
- les fluorohexanones cycliques et/ou aliphatiques, de préférence les perfluorohexanones cycliques et/ou aliphatiques, mieux encore la 1,1,1,2,4,4,5,5,5-nonafluoro-4-(trifluorométhyl)pentan-3-one,
- les fluoroheptanones cycliques et/ou aliphatiques, de préférence les perfluoroheptanones cycliques et/ou aliphatiques,
- l'hexafluorure de soufre, et
- les hydrofluoroéthers.

**8.** Procédé de l'une quelconque des revendications 6 à 7, dans lequel le premier groupe de constituants A comprend:

les constituants azote et oxygène avec des pressions partielles relatives entre $p(N_2)/(p(O_2)+p(N_2)) = 0,7$, $p(O_2)/(p(O_2)+p(N_2)) = 0,3$ et $p(N_2)/(p(O_2)+p(N_2)) = 0,95$, $p(O_2)/(p(O_2)+p(N_2)) = 0,05$, ou
les constituants dioxyde de carbone et oxygène avec des pressions partielles relatives entre $p(CO_2)/(p(O_2)+p(CO_2)) = 0,6$, $p(O_2)/(p(O_2)+p(CO_2)) = 0,4$ et $p(CO_2)/(p(O_2)+p(CO_2)) = 0,99$, $p(O_2)/(p(O_2)+p(CO_2)) = 0,01$, ou
les constituants dioxyde de carbone et azote avec des pressions partielles relatives entre $p(CO_2)/(p(N_2)+p(CO_2)) = 0,1$, $p(N_2)/(p(N_2)+p(CO_2)) = 0,9$ et $p(CO_2)/(p(N_2)+p(CO_2)) = 0,9$, $p(N_2)/(p(N_2)+p(CO_2)) = 0,1$, et
dans lequel le deuxième groupe de constituants B comprend au moins un constituant du groupe constitué par:

la 1,1,1,3,4,4,4-heptafluoro-3-(trifluorométhyl)-butan-2-one avec une pression partielle entre 0,1 bar et 0,7 bar à une température de 20 °C,
la 1,1,1,2,4,4,5,5,5-nonafluoro-4-(trifluorométhyl)-pentan-3-one avec une pression partielle entre 0,01 bar et 0,3 bar à une température de 20 °C,
l'hexafluorure de soufre avec une pression partielle entre 0,1 bar et 2 bar à une température de 20 °C, et
un ou plusieurs hydrofluoroéthers avec une pression partielle entre 0,2 bar et 1 bar à une température de 20 °C.

**9.** Procédé de l'une quelconque des revendications 6 à 8, dans lequel le premier groupe de constituants A comprend:

les constituants azote et oxygène avec des pressions partielles relatives entre $p(N_2)/(p(O_2)+p(N_2)) = 0,75$, $p(O_2)/(p(O_2)+p(N_2)) = 0,25$ et $p(N_2)/(p(O_2)+p(N_2)) = 0,90$, $p(O_2)/(p(O_2)+p(N_2)) = 0,10$, et
dans lequel le deuxième groupe de constituants B comprend le constituant 1,1,1,3,4,4,4-heptafluoro-3-(trifluorométhyl)butan-2-one avec une pression partielle entre 0,25 bar et 0,5 bar et/ou le constituant 1,1,1,2,4,4,5,5,5-nonafluoro-4-(trifluorométhyl)pentan-3-one avec une pression partielle entre 0,02 bar et 0,3 bar à une température de 20 °C.

**10.** Procédé de l'une quelconque des revendications précédentes, dans lequel l'intensité de claquage diélectrique $E_{bd}$ du fluide d'isolation (10) est dérivable en utilisant une pluralité des concentrations de constituant $C_X$, $C_Y$ et $C_Z$ des constituants X, Y et Z selon

$$E_{bd} = S(c_X, c_Y, c_Z, \ldots) \sum_{i=X,Y,Z,\ldots} c_i E_{crit,i}$$

avec $C_X$, $C_Y$ et $C_Z$ étant les concentrations de constituant des constituants X, Y et Z ; avec $E_{crit,X}$, $E_{crit,Y}$ et $E_{crit,Z}$ étant des intensités de champ critique spécifiques d'un constituant des constituants X, Y et Z ; avec S ($C_X$, $C_Y$, $C_Z$) étant un paramètre de synergie spécifique des constituants ; et avec i étant un indice pour les constituants X, Y et Z, dans lequel les constituants X, Y et Z et/ou les concentrations de constituant $C_X$, $C_Y$ et $C_Z$ sont choisis de telle sorte que le paramètre de synergie S ($C_X$, $C_Y$, $C_Z$) est supérieur à 1 pour au moins une combinaison des concentrations de constituant $C_X$, $C_Y$ et $C_Z$.

**11.** Procédé de l'une quelconque des revendications précédentes dans lequel le premier groupe de constituants A comprend les constituants X et Y et le deuxième groupe de constituants B comprend au moins le constituant Z, et dans lequel une intensité de champ critique spécifique d'un groupe de constituants $E_{crit,A}$ pour le premier groupe de constituants A et/ou une intensité de champ critique spécifique d'un groupe de constituants $E_{crit,B}$ pour le deuxième groupe de constituants B est ou sont dérivables selon

$$E_{crit,A} = S_A(c_X, c_Y) \sum_{i=X,Y} c_i E_{crit,i}$$

et/ou

$$E_{crit,B} = S_B(c_Z,...) \sum_{i=Z,...} c_i E_{crit,i}$$

avec $C_X$, $C_Y$ et $C_Z$ étant les concentrations de constituant des constituants X, Y et Z ; avec $E_{crit,X}$, $E_{crit,Y}$ et $E_{crit,Z}$ étant des intensités de champ critique spécifiques d'un constituant des constituants X, Y et Z ; avec $S_A(C_X, C_Y)$ et $S_B(S_Z, ...)$ étant des paramètres de synergie intragroupe de constituants des groupes de constituants A et B ; et avec i étant un indice pour les constituants X et Y pour le groupe de constituants A et au moins pour le composant Z pour le groupe de constituants B.

**12.** Procédé de la revendication 11, dans lequel les constituants X, Y et Z et/ou les concentrations de constituant $C_X$, $C_Y$ et $C_Z$ sont choisis de telle sorte que le paramètre de synergie intragroupe de constituants ou les paramètres de synergie intragroupe de constituants $S_A(C_X, C_Y)$ et/ou $S_B(C_Z, ...)$ est ou sont égaux à 1.

**13.** Procédé de l'une quelconque des revendications précédentes, comprenant en outre l'élément de procédé consistant à dériver l'intensité de claquage diélectrique $E_{bd}$ du fluide d'isolation (10) selon

$$E_{bd} = S(c_A, c_B) \sum_{i=A,B} c_i E_{crit,i}$$

avec $E_{crit,A}$ et $E_{crit,B}$ étant des intensités de champ critique spécifiques d'un groupe de constituants des groupes de constituants A et B ; avec $C_A$ et $C_B$ étant les concentrations de groupe des premier et deuxième groupes de constituants A et B ; avec $S(C_A, C_B)$ étant un paramètre de synergie intergroupe de constituants ; et avec i étant un indice pour les groupes de constituants A et B.

**14.** Procédé de la revendication 13, dans lequel les constituants X, Y et Z et/ou les concentrations de constituant $C_X$, $C_Y$ et $C_Z$ sont choisis de telle sorte que le paramètre de synergie intergroupe de constituants $S(C_A, C_B)$ est supérieur à 1 pour au moins une combinaison des concentrations de groupe $C_A$ et $C_B$ des premier et deuxième groupes de constituants A et B.

**15.** Procédé de l'une quelconque des revendications précédentes, comprenant en outre l'élément de procédé consistant à dériver les concentrations de constituant $C_X$, $C_Y$ et $C_Z$ des constituants X, Y et Z en utilisant les variables de mesure ($\rho$, p, T, $\lambda$, $\eta$, $C_S$) à l'aide d'au moins une équation associée,
dans lequel l'équation associée est identique ou différente pour chacun des constituants X, Y et Z.

**16.** Procédé de la revendication 1 ou 15, dans lequel l'équation associée ou les équations associées est ou sont choisies dans le groupe constitué par: la loi des gaz parfaits, l'équation d'état de Van der Waals, l'équation d'état du viriel, l'équation d'état de Beattie-Bridgeman, et l'équation d'état de Peng-Robinson.

**17.** Procédé de l'une quelconque des revendications précédentes, dans lequel au moins trois variables de mesure ($\rho$, p, T, $\lambda$, $\eta$, $C_S$) sont mesurées au moyen de l'au moins un capteur (30) et dans lequel une ou l'équation associée ou les équations associées est ou sont utilisées pour dériver les concentrations de groupe $C_A$ et $C_B$ des groupes de constituants A et B à l'aide des variables de mesure ($\rho$, p, T, $\lambda$, $\eta$, $C_S$), et
dans lequel l'équation associée ou les équations associées est ou sont des fonctions d'au moins une valeur moyenne pondérée d'un paramètre spécifique d'un constituant, en particulier d'une masse moléculaire (M), pour les premier et deuxième groupes de constituants A et B.

**18.** Procédé des revendications précédentes, dans lequel les variables de mesure ($\rho$, p, T, $\lambda$, $\eta$, $C_S$) sont représentatives au moins de la pression (p), de la température (T) et d'une densité (p) du fluide d'isolation (10).

**19.** Procédé de l'une quelconque des revendications précédentes, dans lequel les variables de mesure ($\rho$, p, T, $\lambda$, $\eta$, $C_S$) sont également représentatives d'au moins un élément du groupe constitué par: une conductivité thermique ($\lambda$), une viscosité ($\eta$), et une vitesse du son ($C_S$) du ou dans le fluide d'isolation (10).

**20.** Procédé de l'une quelconque des revendications précédentes, dans lequel un rapport des concentrations de constituant des constituants dans chaque groupe de constituants A et B est constant ou varie de moins de ± 10 %, de préférence moins de ± 1 %, sur une période d'application du procédé.

**21.** Procédé de l'une quelconque des revendications précédentes, dans lequel le paramètre de fonctionnement P de l'appareil électrique isolé par un fluide (1) est choisi dans le groupe constitué par:

- l'intensité de claquage diélectrique $E_{bd}$ elle-même;
- un état d'un élément indicateur, l'état dépendant de l'intensité de claquage diélectrique $E_{bd}$,
- une variation dans le temps de l'intensité de claquage diélectrique $E_{bd}$, et
- une variable booléenne avec une valeur de variable dépendant de l'intensité de claquage diélectrique $E_{bd}$.

**22.** Procédé de l'une quelconque des revendications précédentes, dans lequel le fluide d'isolation (10) comprend au moins quatre constituants X, Y, Z et ZZ avec des concentrations de constituant $C_X$, $C_Y$, $C_Z$ et $C_{ZZ}$,
le procédé comprenant les éléments de procédé consistant à:

- affecter les au moins quatre constituants à au moins trois groupes de constituants A, B et C avec des concentrations de groupe $C_A$, $C_B$ et $C_C$, au moins un des groupes de constituants comprenant au moins deux des constituants,
- déterminer au moins une quantité du fluide d'isolation (10) qui est représentative des concentrations de groupe,
- dériver l'intensité de claquage diélectrique $E_{bd}$ du fluide d'isolation (10) selon

$$E_{bd} = S(c_A, c_B, c_C, ...) \sum_{i=A,B,C,...} c_i E_{crit,i}$$

avec $E_{crit,i}$ pour i = A, B, C, ... étant des intensités de champ critique spécifiques d'un groupe de constituants des groupes de constituants ; avec $C_i$ pour i = A, B, C, ... étant les concentrations de groupe des groupes de constituants ; avec $S(C_A, C_B, C_C, ...)$ étant un paramètre de synergie intergroupe de constituants ; et avec i étant un indice pour les groupes de constituants A, B, C, ....

**23.** Procédé de dérivation d'une intensité de claquage diélectrique $E_{bd}$ d'un fluide d'isolation (10) pour un appareil électrique isolé par un fluide (1), en particulier pour un appareillage de commutation moyenne ou haute tension isolé au gaz (1), lequel fluide d'isolation (10) comprend au moins trois constituants X, Y et Z avec des concentrations de constituant $C_X$, $C_Y$ et $C_Z$,
le procédé comprenant les éléments de procédé consistant à

- mesurer au moyen d'au moins un capteur (30) une pluralité de variables de mesure ($\rho$, p, T, $\lambda$, $\eta$, $C_S$),
- affecter les au moins trois constituants X, Y et Z à au moins un premier groupe de constituants A avec une concentration de groupe $C_A$ et à au moins un deuxième groupe de constituants B avec une concentration de groupe $C_B$, au moins le premier groupe de constituants A comprenant au moins deux des constituants X, Y et Z ou au moins le deuxième groupe de constituants B comprenant au moins deux des constituants X, Y et Z,
- déterminer, à l'aide des variables de mesure ($\rho$, p, T, $\lambda$, $\eta$, $C_S$), la concentration de groupe $C_A$ du premier groupe de constituants A et la concentration de groupe $C_B$ du deuxième groupe de constituants B, et
- dériver l'intensité de claquage diélectrique $E_{bd}$ à l'aide de la concentration de groupe $C_A$ et de la concentration de groupe $C_B$.

**24.** Procédé selon l'une quelconque des revendications précédentes, dans lequel chaque fois que l'intensité de claquage diélectrique $E_{bd}$ du fluide d'isolation (10) diminue au-dessous d'un seuil, en particulier quand l'appareil électrique (1) quitte un état de fonctionnement « opérationnel » tel que défini par le paramètre de fonctionnement P, un signal d'alerte est émis, en particulier à partir d'une unité de commande 40, à un utilisateur, et/ou l'appareil électrique (1) est arrêté.

**25.** Procédé de fonctionnement d'un appareil électrique isolé par un fluide (1), en particulier d'un appareillage de commutation moyenne ou haute tension isolé au gaz, utilisant un procédé de l'une quelconque des revendications 1 à 24.

**26.** Procédé de la revendication 25, comprenant en outre un élément de procédé consistant à faire circuler le fluide d'isolation (10) pour homogénéiser une densité et/ou un mélange du premier et/ou du deuxième et/ou du troisième constituant X, Y et/ou Z, en particulier avant de réaliser l'élément de procédé consistant à dériver les concentrations

de groupe $C_A$ et $C_B$ des groupes de constituants A et B.

**27.** Procédé de l'une quelconque des revendications 25 à 26, comprenant en outre au moins un élément de procédé du groupe constitué par:

- l'augmentation d'au moins une des concentrations de constituant $C_X$, $C_Y$ et/ou $C_Z$ des constituants X, Y et/ou Z du fluide d'isolation (10), en particulier au moyen de l'injection d'une quantité d'au moins un des constituants X, Y et/ou Z à partir d'un réservoir de constituant (70) dans un compartiment (50) de l'appareil électrique (1),
- la réduction d'au moins une des concentrations de constituant $C_X$, $C_Y$ et/ou $C_Z$ des constituants X, Y et/ou Z du fluide d'isolation (10),
- la réduction d'une concentration d'au moins un contaminant dans le fluide d'isolation (10), en particulier au moyen d'un filtre (90),
- l'évaporation au moins partielle d'une quantité condensée d'au moins un des constituants X, Y et/ou Z du fluide d'isolation (10), en particulier au moyen d'un dispositif de chauffage (80), et
- la condensation d'une quantité d'au moins un des constituants X, Y et/ou Z du fluide d'isolation (10), en particulier au moyen d'un dispositif de refroidissement.

**28.** Appareil électrique isolé par un fluide (1), qui est un appareillage de commutation moyenne ou haute tension isolé au gaz ou un transformateur, comprenant:

un fluide d'isolation (10) qui comprend au moins trois constituants X, Y et Z,
au moins un capteur (30) pour mesurer une pluralité de variables de mesure ($\rho$, p, T, $\lambda$, $\eta$, $C_S$), et
une unité de commande et d'analyse (40) adaptée pour réaliser les étapes ou éléments de procédé du procédé de la revendication 1, comportant:

- la dérivation d'au moins un paramètre de fonctionnement P de l'appareil électrique isolé par un fluide (1), lequel paramètre de fonctionnement dérivé P dépend d'une intensité de claquage diélectrique $E_{bd}$ du fluide d'isolation (10) de l'appareil électrique (1) et définit un état de fonctionnement opérationnel ou un état de défaillance de l'appareil électrique (1),
- la mesure au moyen de l'au moins un capteur (30) de la pluralité des variables de mesure ($\rho$, p, T, $\lambda$, $\eta$, $C_S$), les variables de mesure ($\rho$, p, T, $\lambda$, $\eta$, $C_S$) étant représentatives au moins d'une pression (p) et d'une température (T) du fluide d'isolation (10),
- l'affectation des au moins trois constituants X, Y et Z à au moins un premier groupe de constituants A avec une concentration de groupe $C_A$ et à au moins un deuxième groupe de constituants B avec une concentration de groupe $C_B$, au moins le premier groupe de constituants A comprenant au moins deux des constituants X, Y et Z ou au moins le deuxième groupe de constituants B comprenant au moins deux des constituants X, Y et Z,
- dans lequel les au moins trois constituants X, Y et Z sont affectés aux au moins deux groupes de constituants A et B de telle sorte qu'une valeur moyenne pondérée $M_A$ d'une masse moléculaire du constituant ou des constituants dans le premier groupe de constituants A diffère d'une valeur moyenne pondérée $M_B$ d'une masse moléculaire du constituant ou des constituants dans le deuxième groupe de constituants B,
- la dérivation des concentrations de groupe $C_A$ et $C_B$ des groupes de constituants A et B à l'aide des variables de mesure ($\rho$, p, T, $\lambda$, $\eta$, $C_S$) et d'au moins une équation associée, qui est identique ou différente pour chacun des groupes de constituants A et B, et
- la dérivation du paramètre de fonctionnement P à l'aide de la concentration de groupe $C_A$ et de la concentration de groupe $C_B$.

**29.** Appareil électrique isolé par un fluide (1), qui est un appareillage de commutation moyenne ou haute tension isolé au gaz ou un transformateur, comprenant:

un fluide d'isolation (10) qui comprend au moins trois constituants X, Y et Z,
au moins un capteur (30) pour mesurer une pluralité de variables de mesure ($\rho$, p, T, $\lambda$, $\eta$, $C_S$), et
une unité de commande et d'analyse (40) adaptée pour réaliser les étapes ou éléments de procédé du procédé de la revendication 23, comprenant:

- la dérivation d'une intensité de claquage diélectrique $E_{bd}$ du fluide d'isolation (10),
- la mesure au moyen de l'au moins un capteur (30) de la pluralité de variables de mesure ($\rho$, p, T, $\lambda$, $\eta$, $C_S$),
- l'affectation des au moins trois constituants X, Y et Z à au moins un premier groupe de constituants A

avec une concentration de groupe $C_A$ et à au moins un deuxième groupe de constituants B avec une concentration de groupe $C_B$, au moins le premier groupe de constituants A comprenant au moins deux des constituants X, Y et Z ou au moins le deuxième groupe de constituants B comprenant au moins deux des constituants X, Y et Z,
- la détermination, à l'aide des variables de mesure ($\rho$, p, T, $\lambda$, $\eta$, $C_S$), de la concentration de groupe $C_A$ du premier groupe de constituants A et de la concentration de groupe $C_B$ du deuxième groupe de constituants B, et
- la dérivation de l'intensité de claquage diélectrique $E_{bd}$ à l'aide de la concentration de groupe $C_A$ et de la concentration de groupe $C_B$.

**30.** Élément de programme informatique comprenant un moyen de code de programme informatique pour, lorsqu'il est exécuté par une unité de traitement, mettre en oeuvre un procédé selon l'une quelconque des revendications 1 à 27.

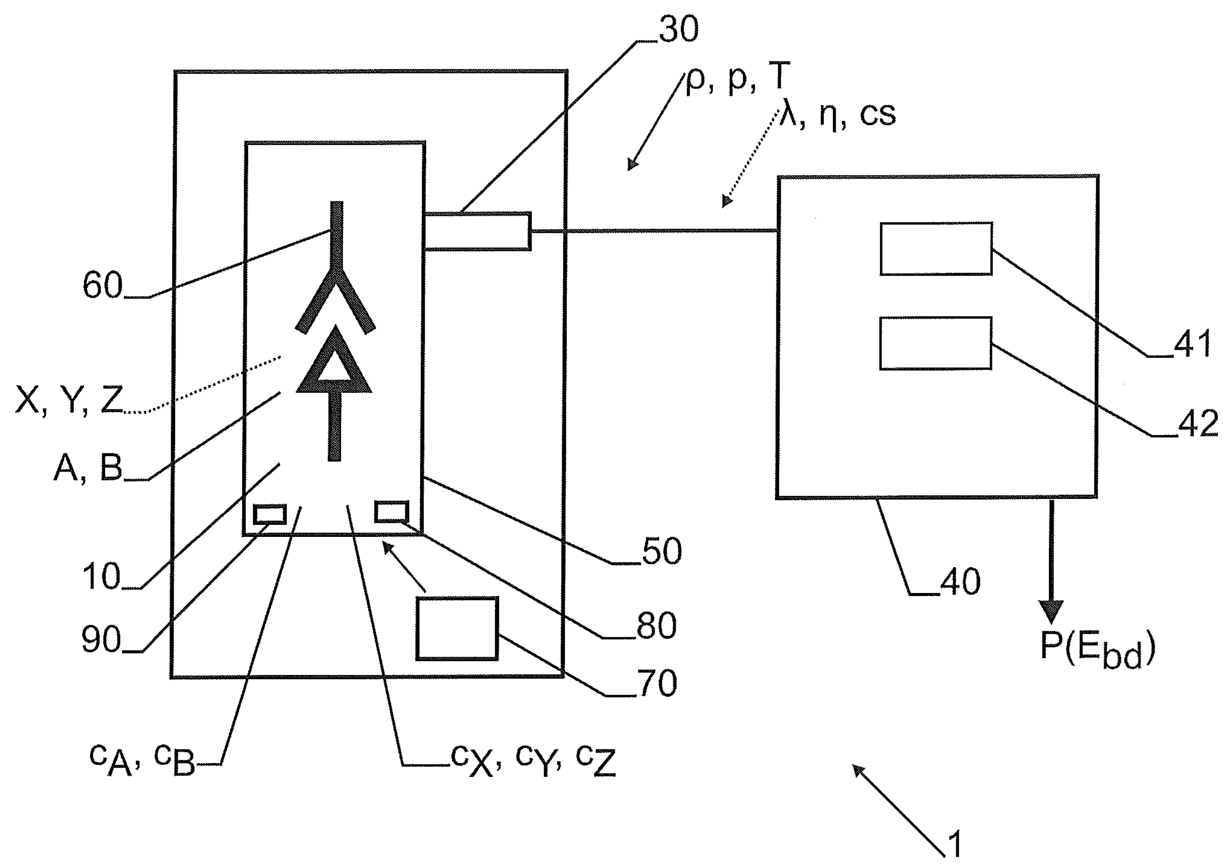
30
ρ, p, T
λ, η, cs
60
X, Y, Z
A, B
10
90
41
42
50
80
70
40
P(Ebd)
cA, cB
cX, cY, cZ
1

Fig. 1

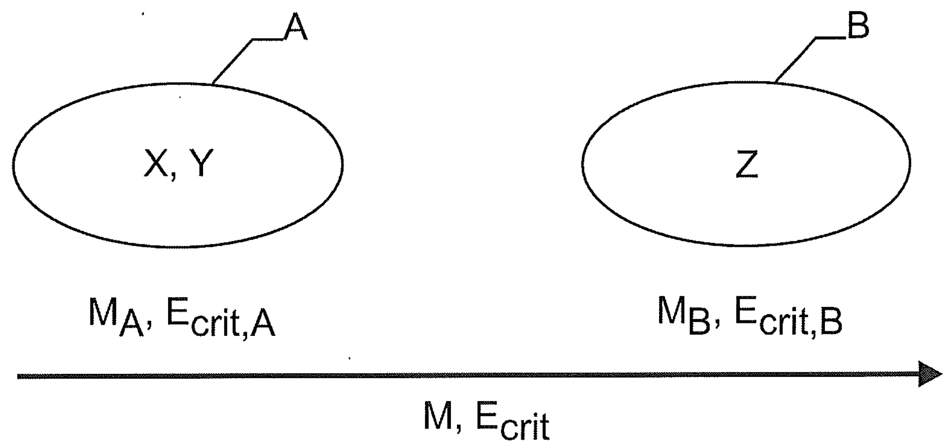
A
B
X, Y
Z
MA, Ecrit,A
MB, Ecrit,B
M, Ecrit

Fig. 2

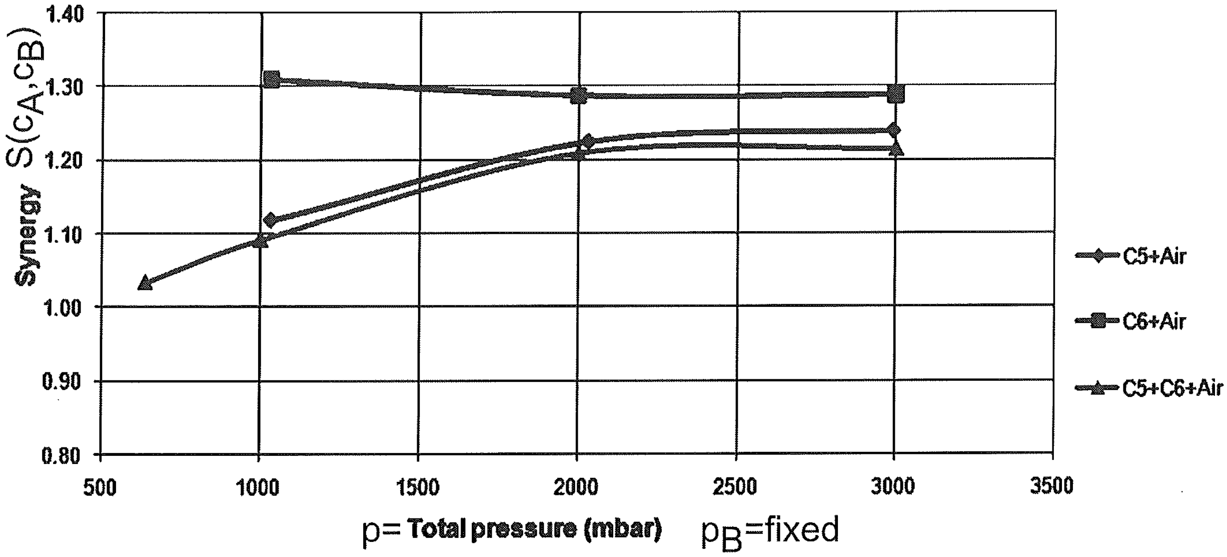


Fig. 3

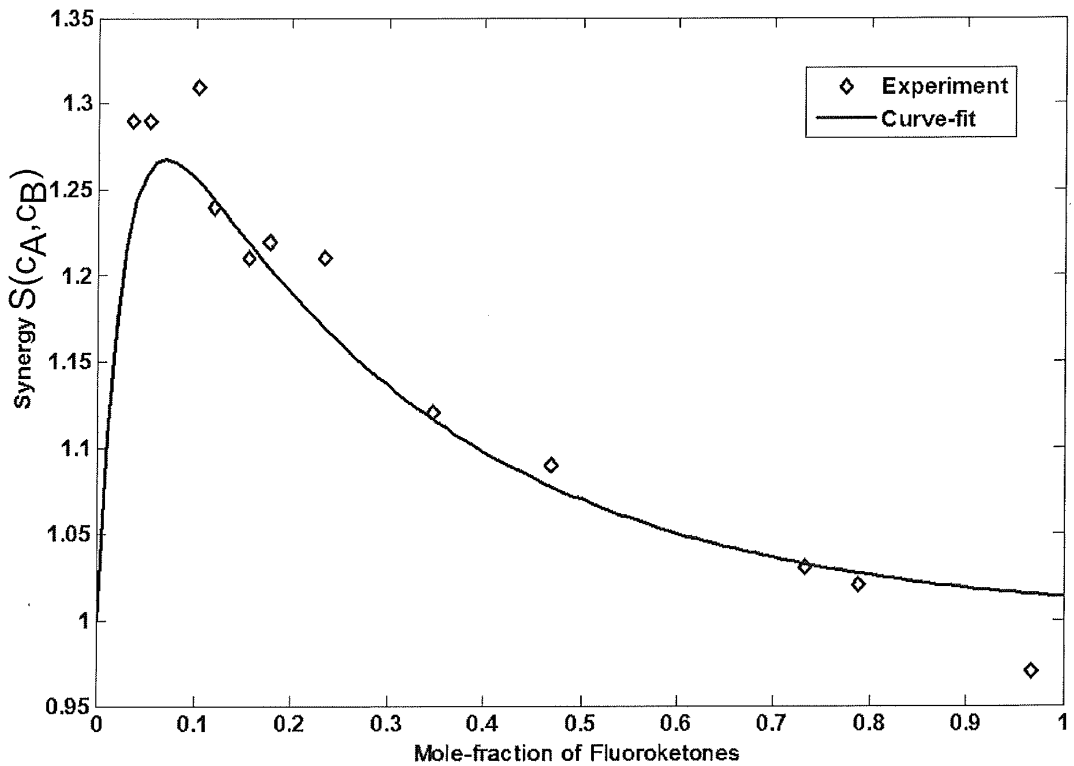


Synergy(x) $=0.37\left[e^{-x/0.3} - e^{-x/0.026}\right] + 1$; where x is the mole fraction of C5/C6 in air

Fig. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20020095262 A1
- US 7184895 B2
- US 20070221626 A1
- EP 1085635 A2
- US 6276190 B1
- WO 2010043268 A1
- US 6305212 B1
- US 6272905 B1
- EP 2011072515 W
- EP 2012067217 W


### Non-patent literature cited in the description


- CBWatch-2 Modular circuit breaker monitoring system. *Alstom Product Brochure,* 01 September 2010, 1-4
- *thermodynamic equation describing the state of matter under a given set of physical conditions,* 16 November 2011, http://en.wikipedia.org/wiki/Equation_of_state
- **T. LÖFQUIST.** *SPEED OF SOUND MEASUREMENTS IN GAS-MIXTURES AT VARYING COMPOSITION USING AN ULTRASONIC GAS FLOW METER WITH SILICON BASED TRANSDUCERS,* 18 November 2011, http://pure.ltu.se/portal/files/60931/artikel.pdf
- *a substance, such as a liquid [and/] or gas, that can flow, has no fixed shape, and offers little resistance to an external stress,* 09 November 2011, http://www.thefreedictionary.com/fluid